(19) Europäisches Patentamt / European Patent Office / Office européen des brevets

(11) **EP 4 478 859 A1**

(12) **EUROPEAN PATENT APPLICATION**


(43) Date of publication:
**18.12.2024 Bulletin 2024/51**

(21) Application number: **23178742.5**

(22) Date of filing: **12.06.2023**

(51) International Patent Classification (IPC):
***H10K 30/40*** *(2023.01)* ***H10K 30/80*** *(2023.01)*
***H10K 85/10*** *(2023.01)* ***H10K 85/60*** *(2023.01)*
***C07D 471/16*** *(2006.01)*

(52) Cooperative Patent Classification (CPC):
**H10K 30/40; H10K 30/80; H10K 85/113; H10K 85/6572;** H10K 30/50; H10K 85/50

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**



(71) Applicant: **ECOLE POLYTECHNIQUE FEDERALE DE LAUSANNE (EPFL)**
**1015 Lausanne (CH)**

(72) Inventors:
- **Nazeeruddin, Mohammad Khaja**
  **1024 Ecublens (CH)**
- **Dyson, Paul**
  **1024 Ecublens (CH)**
- **Xia, Jianxing**
  **Santai, 621119 (CN)**
- **Pozzi, Gianluca**
  **24031 Almenno San Salvatore (BG) (IT)**
- **Cavazzini, Marco**
  **20154 Milano (IT)**
- **Orlandi, Simonetta**
  **20149 Milano (IT)**

(74) Representative: **ABREMA SA**
**Avenue du Théâtre 16**
**1005 Lausanne (CH)**


(54) **PHOTOVOLTAIC OR OPTOELECTRONIC DEVICES WITH MOLECULAR ORBITAL STRETCHING JUNCTIONS**


(57) The invention relates to a dopant-free perovskite optoelectronic or photovoltaic device presenting molecular orbital stretching junction, wherein the hole transport layer is a multilayer structure comprising at least two layers, each layer comprising a different hole transport material (HTM) having a different ionization energy (IP) for each layer and selected from donor material or acceptor material. The sequence of the layers in the multilayer structure of the hole transport layer is configured such that the layer of the hole transport layer in direct contact with the light-harvesting layer (4) is a layer comprising a donor material with an IP value being ≤-5.00 eV and ≥-5,60 eV, which is equal to or higher than the IP value of the organic/inorganic metal halide perovskite, the IP value of each HTM being lower than the work function of a material of the back contact or the counter electrode.


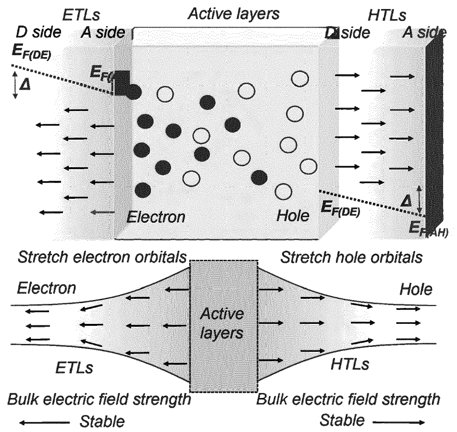


Figure 1B

EP 4 478 859 A1

# Description

## Technical Field

The present invention relates to ullazine-based compounds, hole transporting material comprising an ullazine-based compound, and photovoltaic or optoelectronic devices comprising ullazine-based hole transporting material and/or in combination with donor and/or acceptor compounds to generate molecular orbital stretching junction.

## Prior Art and the Problem Underlying the Invention

In perovskite solar cells (PSCs), hole collection via hole transport materials (HTMs) can be mainly divided into injection and transport processes. The photo-generated charges of PSCs are collected by the electron transport layers (ETLs) and hole transport layers (HTLs). In general, the carrier collection primarily splits into processes of interfacial injection and bulk transportation within ETLs or HTLs, wherein the injection driven by the heterojunction contact induces vertically oriented interfacial built-in field, related to the quasi-Fermi level and the band offset positions. The transportation of carriers within bulk materials is dominated by mobility induced self-drifting, and the incidence of directional transportation of carriers decreases as the thickness of charge transport layers (CTLs) increases. The bulk random carrier drifting reduces the efficiency of charge collection and the open-circuit voltage ($V_{oc}$) of PSCs, and it is specially prominent within dopant-free HTMs usually characterized by low charge mobility. For traditional sandwich PSCs, the theoretical $V_{oc}$ of devices is typically expressed by equation that considers only the quasi-Fermi levels of the specific ETLs ($E_{Fn}$) and HTLs ($E_{Fp}$): $eV_{oc} = E_{Fn} - E_{Fp}$. This simplified approach (Figure 1A) does not take into account, among others, the contribution of carriers collection processes. The development of hole-transport materials with high mobility, long-term stability and comprehensive passivation is significant for simultaneously improving the efficiency and stability of perovskite solar cells.

At present, 2,2',7,7'-tetrakis(N,N-di-p-methoxyphenylamine)-9,9'-spirobifluorene (spiro-OMeTAD) is the most prevalent used HTM in PSCs with high efficiencies. However, due to the low hole mobility of spiro-OMeTAD, the hole extraction and transportation are enhanced by using ionic p-dopants. The doping process will not only increase the complexity of device fabrication but also caused accelerated degradation of PSCs due to the hygroscopicity of the dopants and the subsequent moisture absorption. Further, the migration of dopants would cause harmful effects on the long-term stability of the devices. Therefore, the development of dopant-free HTMs is essential to achieve PSCs which are performant and stable.

Derivatives based on ullazine core have been used as dopant-free HTMs. But they yield moderate power conversion efficiencies in the range of 13%. Most dopant-free HTMs are sub-optimal in their transport property due to low hole mobility. Despite appropriate energy levels for hole injection into the perovskite layer, their use in PSCs results in low power conversion efficiencies (PCE).

To improve the conductivity of ullazine-based HTMs, molecular engineering was used to design ullazine-based HTM with tunable HUMO-LUMO (Highest Occupied Molecular Orbital-Lowest Unoccupied Molecular Orbital) energy levels. Thus, thienyl functionalized ullazine-based HTM have been synthesized allowing the modulation of the electronic states of the HTMs and further providing defect passivation of the perovskite surface of PSCs. The efficiency of PSCs comprising such HTMs increases to a value (~20,21%) close to the performance of spiro-OMeTAD (Xia et al. (2022), Solar RRL, 10.1002/solr.202100926, vol 6, 4). However, the practical application of molecular engineering represents tedious, time-consuming and resource-intensive work to obtain ullazine-based HTMs with an optimal combination of substituents or donor-acceptor groups and with acceptable tuned HUMO-LUMO levels allowing improved hole mobility without destabilizing the perovskite layer and then, the device.

In addition to the molecular design, new strategies for improving the hole mobility in the bulk of hole transporting flow in PSCs as well as the device stability are necessary.

The present invention addresses the problem of the low hole mobility of HTMs and, in particular, dopant-free HTMs. The problems of the device instability due to the composition of dopant-free HTMs as well as due to the long-term operation endured by PSCs and planar-structured PSCs are also addressed.

The present invention further addresses the problem of the limited applicability of HTMs, including already-existing or commercially available HTMs with low hole mobility and used without doping. In particular, the problem of the hole motility in the hole transporting flow in the hole transporting layer of ullazine-based HTMs is addressed as well as the problem of the directional carriers transportation within bulk charge transport layers (CTLs).

## Summary of the Invention

To address the problems depicted above, the present invention proposes to improve the efficiency of PSCs by enhancing the directional transportation of carriers in bulk CTLs.

The inventors have found that a stacked layer design comprising different HTMs, which combines donor

materials, which can be selected from ullazines with low hole mobility or from polymeric p-type semiconductor, with additional donor and/or acceptor compounds, creates an additional electric field in the bulk CTLs. This combination of donor and acceptor materials on the basis of their Ionization Energy (IP) generates molecular orbital stretching (MOS) junctions, in which, due to the extra electric field, electrons and holes exhibit stretched orbitals and enhanced directional carrier drift compared to the flat charge carriers orbitals in the conventional junction of solar cells. This stacked layer design combining donor and acceptor materials as HTMs involves reducing the carrier transport freedom and stabilizing the electric field in the bulk CTLs. As a result, hole transport in the bulk of organic semiconductors is enhanced, especially in dopant-free HTMs with low hole mobility.

Furthermore, the devices based on organic dopant-free HTMs are stable within all kind of environmental conditions (ambient, thermal and operating) and the fabrication costs remains low.

According to one aspect, the present invention provides an optoelectronic or photovoltaic device comprising a light-harvesting layer 4 comprising an organic/inorganic metal halide perovskite, a hole transport layer 5 and a back contact or a counter electrode 6, **characterized in that** the hole transport layer 5 is a multilayer structure, being sandwiched between the light-harvesting layer and the back contact or the counter electrode, and comprising at least two layers, each layer comprising a different hole transport material (HTM) having a different ionization energy (IP) for each layer and being selected from donor material or acceptor material; and **in that** the layer of the hole transport layer 5 in direct contact with the light-harvesting layer (4) is a layer comprising a donor material with an IP value ≤-5.00 eV and ≥-5.60 eV and being equal to or higher than the IP value of the organic/inorganic metal halide perovskite, and **in that** the IP value of each HTM is lower than the work function of a material of the back contact or the counter electrode.

According to a further aspect, the present invention provides a hole transport material comprising an ullazine derivative selected from a compound of formula (I)

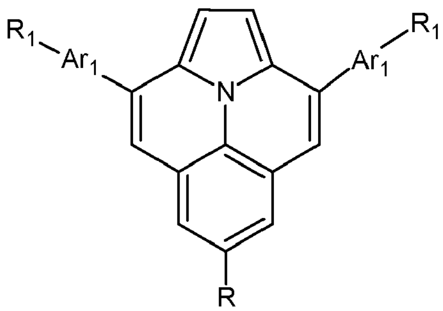

formula I,

wherein

- $Ar_1$ are identical or different, and selected from unsubstituted C6 aryl or unsubstituted C4-C5 heteroaryl comprising a heteroatom selected from O, S and N;
- $R_1$ are identical or different substituents, and selected from a moiety according to any one of formulae (Ia) and (Ib) below:

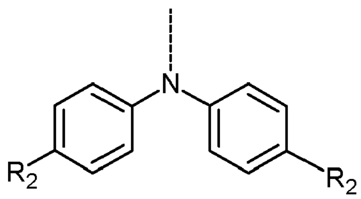

(Ia),

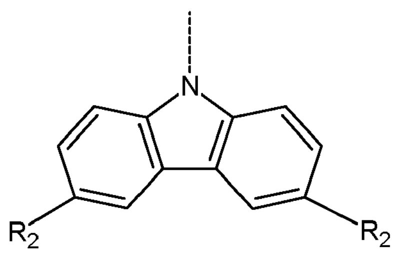

(Ib),

wherein $R_2$ are identical or different substituents and are selected from H, hydrocarbyl group comprising 1-20 carbon atoms, or hydrocarbyl group comprising 1 to 20 carbon atoms and 1 to 10 heteroatoms selected from O, S or N. wherein said hydrocarbyl groups, if said hydrocarbyl groups comprise 3 or more carbons, may be linear or branched and are unsubstituted or further substituted by halogen being selected from F, Cl, Br or I;

wherein the dotted line in the structures of formulae (Ia) and (Ib) represents a single bond by which substituent $R_1$ is linked to $Ar_1$; and

- R is selected from H, halogen selected from F, Cl, Br or I, moiety of formula (Ia), moiety of formula (Ib), C1-C15 alkyl

group, C1-C15 heteroalkyl group, C2-C15 alkenyl group, or C2-C15 alkynyl group, wherein one or more heteroatoms are selected from N, S or O, wherein said alkyl, heteroalkyl, alkenyl and alkynyl group, if they comprise 3 or more carbons, may be linear or branched and wherein alkyl, heteroalkyl, alkenyl, alkynyl groups are unsubstituted or further substituted by halogen being selected from F, Cl, Br or I.

Further aspects and preferred embodiments of the invention are detailed herein below and in the appended claims. Further features and advantages of the invention will become apparent to the skilled person from the description of the preferred embodiments given below.

## Brief Description of the Drawings

**Figure 1A:** Scheme of the conventional junction of a solar cell, in which the carriers transporting flow is represented in flat electron and hole orbitals. **Figure 1B:** Scheme of the orbital stretching-junction of a solar cell, in which the carriers transporting flow is represented in stretched electron and hole orbitals.

**Figure 2A:** Chemical structures of donor compounds (D1) selected from ullazine-based HTMs. **Figure 2B:** Chemical structures of donor compounds (D2) selected from polymeric HTMs: P3HT and PDCBT and chemical structures of acceptor compounds (A) selected from BCF, N-PBA and Na-PBA.

**Figure 3A:** Schemes of the mechanisms of donor-acceptor (DA), donor-donor (DD) and donor-donor-acceptor (DDA) in the molecular orbital stretching-junction (MOS) upon molecular contact. **Figure 3B:** Schemes of the stretched electron orbitals (SEO) and the stretched hole orbitals (SHO) in the above-mentioned mechanisms.

**Figure 4A:** Graphic of the hole mobility of ullazine-based HTMs measured by XTOF. **Figure 4B:** left: Graphic of electronic density of SHO of donor PDCBT within the DA-MOS PDCBT-BCF (PB) as compared to the SHO of PDCBT; right: Graphic of electronic density of SEO of PDCBT within the DA-MOS (PB) as compared to the SEO of PDCBT.

**Figure 5A:** Scheme of an optoelectronic or photovoltaic device according to an embodiment of the invention, wherein the HTL 5 is a bilayer comprising a layer of donor HTM 5a and a layer of acceptor HTM 5b. **Figure 5B:** Scheme of an optoelectronic or photovoltaic device according to a further embodiment of the invention, wherein the HTL is a bilayer comprising a layer of donor HTM 5a and a layer of donor HTM 5b. **Figure 5C**: Scheme of an optoelectronic or photovoltaic device according to a further embodiment of the invention, wherein the HTL consists of three layers comprising a layer of donor HTM 5a, a layer of donor HTM 5b and a layer of acceptor HTM 5c. Conducting support layer 1, n-type semiconductor layer 2, electron transport layer 3, light-harvesting layer 4, HTL 5, back contact 6 or counter electrode 6.

**Figure 6:** top: Power conversion efficiencies (PCE) of dopant-free PSCs comprising a HTM selected from ullazine derivatives as dopant-free HTM or as donor in DDA-MOS based solar cell; bottom: PCEs of dopant-free PSCs comprising an ullazine derivative (ULLA9) as donor in DDA-MOS based solar cell.

**Figure 7A:** left: J-V curves of PSCs based on dopant free ullazine derivatives (ULLAs); right: J-V curves of PSCs based on ULLAs/PDCBT dyads (DD-MOS: 8-11P). **Figure 7B:** left: J-V curves of PSCs based on PDCBT/acceptor (Na-PBA, N-PBA, BCF) dyads (DA-MOS: PNa, PN, PB); right: J-V curves of PSCs based on ULLAs/PDCBT/acceptor (BCF) triads (DDA-MOS: 8-11PB).

**Figure 8A:** Photovoltaic properties of PSCs modules and stability, left: J-V curves of PSCs modules based on DDA-MOS: ULLA9/PDCBT/BCF (9PB) and DDA-MOS: ULLA9/P3HT/BCF (9HB) - estimated designated illumination aperture area: 33.2 $cm^2$; right: Comparison of J-V curves of reverse and forward scans of PSC modules based on DDA-MOS (9PB) and DDA-MOS (9HB). **Figure 8B:** left: operating stability of PSCs based on DDA-MOS (9PB) and DDA-MOS(9HB) under 1 sun illumination, $N_2$, 25°C; right: operating stability of PSCs based on DDA-MOS (9PN) and DDA-MOS(9PNa) under 1 sun illumination, $N_2$, 25°C.

## Detailed Description of the invention

In the following. embodiments of the invention shall be described in detail with reference to the above-mentioned figures.

In one aspect, the invention concerns an optoelectronic or photovoltaic device of the present invention comprising a light-harvesting layer 4 comprising an organic/inorganic metal halide perovskite, and a hole transport layer 5 **characterized in that** the hole transport layer 5 is a multilayer structure comprising at least two layers, each layer comprising a different hole transport material having a different ionization energy (IP) for each layer and being selected from donor material or acceptor material; and **in that** the sequence of the layers in the multilayer structure is configured in that the layer of the hole transport layer 5 in direct contact with the light-harvesting layer 4 is a layer comprising a donor material with an IP value being ≤-5.00 eV and ≥-5.60 eV and being equal to or higher than the IP value of the

organic/inorganic metal halide perovskite and **in that** the IP value of each HTM is lower than the work function of a material of the back contact or the counter electrode.

The donor material of the layer of the HTL in direct contact with the light-harvesting layer and the organic/inorganic metal halide perovskite can be isoenergetic, i.e., the IP value of the donor material of said layer being equal to the IP value of the organic/inorganic metal halide perovskite. When the organic/inorganic metal halide perovskite and the donor material are isoenergetic, the donor material has a HOMO energy level being equivalent to the energy level of the valence band of the organic/inorganic metal halide perovskite. In the other hand, the IP value of the donor material of said layer can higher than the IP value of the organic/inorganic metal halide perovskite, the donor material having an energy gap between the HOMO energy level of said donor material and the energy level of the valence band of the organic/inorganic metal halide perovskite being ≥ 0.05 eV and ≤ 0.60 eV, preferably being ≥ 0.10 eV and ≤ 0.45 eV.

For the purpose of the present specification, the expression "valence band" means the band of electron orbitals that electrons can jump out of, moving into the conduction band when excited. The valence band is simply the outermost electron orbital of an atom of any specific material that electrons actually occupy.

The expression "the conduction band" means the band of electron orbitals that electrons can jump up into from the valence band when excited. When the electrons are in these orbitals, they have enough energy to move freely in the material.

The "work function" of a material of the back contact or the counter electrode, which may, in particular, be a metal, is the minimum amount of energy necessary to start the emission of electrons from the metal surface. The method of measuring the work function may be selected from photoelectron (PE) method characterizing the kinetic energies of emitted electrons owing to photon adsorption. Modern photoelectron spectroscopy can use both X-rays (X-ray photoelectron spectroscopy (XPS)) and ultraviolet light as sources of incident photons (ultraviolet photoelectron spectroscopy (UPS)), often in a single equipment.

HOMO stands for Highest Occupied Molecular Orbital. The HOMO represents the highest energy level that is fully occupied by electrons (ionization potential). LUMO stands for Lowest Unoccupied Molecular Orbital. It refers to the energy level of the lowest energy molecular orbital that does not contain any electrons in a molecule or material (reduction potential or electron affinity). These energy levels are important because they play a crucial role in various electronic and optical properties of molecules and materials.

In the conventional junction of n-i-p PSCs (Figure 1A), the electric field strength in each junction decreases with increasing thickness of CTLs and the electron and hole orbitals are schematically simplified and represented as flat orbitals. It is generally assumed that flat orbitals allow high freedom degree of carrier transportation due to the decreased electric field with increasing CTLs thickness.

In an optoelectronic device of the invention, the combination of donor and acceptor compounds in the CTLs according to a determined sequence shall result in additional electric field in the junctions of the perovskite-based optoelectronic device. The extra electric field influences and re-directs the carriers drifting in the CTLs by decreasing the freedom degree of the carrier transportation (Figure 1B).

As demonstrated below, in addition to the classical quasi-Fermi level splitting that determines the theoretical value of the open-circuit voltage ($V_{oc}$), $V_{oc}$ is further related to the electron-hole orbital stretching as well as the orbital density of states. Considering the bulk transportation of HTMs and ETMs, the additional $V_{oc}$ of a PSC can be expressed as follows: according to the Fermi-Dirac function, the total $V_{oc}$ of a solar cell is expressed by:

$$eV_{oc} = \Delta E_q + \Delta E_{HTM} + \Delta E_{ETM} = E_{Fn} - E_{Fp} + K_B T ln\left(\frac{1-F(E_{AH})}{F(E_{AH})}\right) - K_B T ln\left(\frac{1-F(E_{DH})}{F(E_{DH})}\right) + K_B T ln\left(\frac{1-F(E_{DE})}{F(E_{DE})}\right) - K_B T ln\left(\frac{1-F(E_{AE})}{F(E_{AE})}\right),$$

wherein $K_B$ is Boltzmann constant, T is temperature, e is the charge of electron, $E_{Fn}$ is the quasi-Fermi level of ETL after shifting, and pristine $E_{Fp}$ is the quasi-Fermi level of HTL after shifting, F(E) is the Fermi-Dirac distribution function expressing the probability of electron occupancy between conduction band and valence band, and subscripts AH, DH, DE and AE of F(E) indicate the HTMs surface of acceptor electron to vacuum, HTMs surface of donor electron, ETMs surface of donor electron and ETMs surface of acceptor electron to vacuum, respectively. The charge hopping which leaves the positive within the valence band side *via* charge neutrality equation can be expressed by: $p^+ = \int DOS(E)[1 - F(E)]\, dE = \int \alpha(E)\, dE$ and the conduction band charge concentration can be expressed by: $n = \int DOS(E)F(E)\, dE = \int \beta(E)\, dE$, wherein the DOS(E) is the density of states within the semiconductor surface, wherein $\alpha(E)$ and $\beta(E)$ are the defined function related to the valence band orbital width and conduction band orbital width (dE). The integration of $\alpha(E)$ and $\beta(E)$ are constants, which are the inverse function of the orbital width stretching. Thus, when the orbitals expand, the $\alpha(E)$ and $\beta(E)$ will decrease, and vice versa. The additional $V_{oc}$ of the PSCs in the bulk of HTMs and ETMs can be further expressed by:

$$\Delta V_{oc} = \frac{K_B T}{e} ln\left(\frac{\alpha(E_{AH})[DOS(E_{DH}) - \alpha(E_{DH})]}{\alpha(E_{DH})[DOS(E_{AH}) - \alpha(E_{AH})]}\right) + \frac{K_B T}{e} ln\left(\frac{\beta(E_{DE})[DOS(E_{AE}) - \alpha(E_{AE})]}{\beta(E_{AE})[DOS(E_{DE}) - \alpha(E_{DE})]}\right),$$

wherein, the left part of the equation represents the additional $V_{oc}$ within bulk HTMs and, the right part of the equation represents the additional $V_{oc}$ within bulk ETMs. When shrinking the hole orbitals of HTMs from the D-side (donor side) to the A-side (acceptor side), a higher value is obtained on the left side of the equation, while a reduced value is obtained for the expansion of the hole orbitals from the D-side to the A-side. When shrinking the electron orbitals of ETMs from the A-side to the D-side, a lower value is obtained on the right side of the equation, and a higher value is obtained for the expansion of the electron orbitals from the A-side to the D-side (Figure 1B). Thus, the electron concentrations on both sides of the CTLs vary as well as the quasi-Fermi level on both sides (D-side and A-side) of ETMs and HTMs. Considering that the electron donor (D) to the CTLs is on the right side of the HTMs and ETMs and, on the other hand, the acceptor (A) loses electron from the right side of the ETMs and the HTMs, this results in a driving force through the ETMs and HTMs which regulates carrier transportation and favors the hole transport within the organic semiconductor.

Because of the additional electric field inside the bulk CTLs, the optoelectronic device or photovoltaic device of the invention presents stretched hole or electron orbitals and a directional electron transportation (Figure 1B) and comprises MOS junctions of HTLs and/or ETLs. In the MOS junction, the stretched orbitals reduce the freedom degree of carrier transportation and stabilize the electric field in the bulk CTLs. The stretched orbitals in the MOS junctions of an optoelectronic device of the invention allows injection of more carriers from the active layer (light-harvesting layer) due to the increased contact surface of the expanding orbitals. The shrinking orbitals accumulate the carriers and stress the carrier transport in one direction.

Without to be bound by the theory, the combination of organic p-type semiconductors having different electronic properties in the HTL of the optoelectronic or photovoltaic device of the invention allows suitable charge transfer upon molecular contact and the generation of an extra electric field in the HTLs. The combination of said organic p-type semiconductor follows a determined arrangement or sequence in order to favour the hole flow and its direction towards the back contact and to preserve the regeneration of the active layer comprising the organic/inorganic metal halide perovskite. Each layer of the HTL comprises a different donor or acceptor material and the layer of the HTL in direct contact with the light-harvesting layer comprises a donor material having an IP higher than the IP of the organic/inorganic metal halide perovskite to direct the hole transfer to vacuum and ensure the regeneration of the active layer.

In a device of the present invention, in addition that the donor material of a layer of the multilayer structure of the HTL has a HOMO energy level being equivalent to the energy level of the valence band of the organic/inorganic metal halide perovskite, respectively, or has an energy gap between the HOMO energy level of said donor material and the energy level of the valence band of the organic/inorganic metal halide perovskite being $\geq 0.05$ eV and $\leq 0.60$ eV, the IP value of the donor material in the HTL of the MOS junction is lower than the work function or HOMO energy level of the material of the back contact or counter electrode.

MOS junctions can be generated in the ETLs as well to the HTLs to improve the carrier flow in PSCs. Because of the low hole mobility in dopant-free HTMs and the instability of PSCs caused by the addition of dopant to improve the hole transport, MOS junction is preferably created in the HTL to improve the efficiency of PSCs comprising dopant-free HTMs.

As for measuring the energy levels in the conduction band, valence band, and the ionization potential (IP), there are several experimental techniques used in materials science. These methods considering as standard methods for measuring energy levels are, but not limited to Ultraviolet Photoelectron Spectroscopy (UPS), Cyclic Voltammetry (CV) X-ray Photoelectron Spectroscopy (XPS) and Kelvin Probe Force Microscopy (KPFM). UPS is a technique that measures the kinetic energy of photoelectrons emitted from a sample upon absorption of ultraviolet (UV) photons. By varying the energy of the incident photons, the energy levels of the valence band and the ionization potential (IP) can be determined. The valence band corresponds to the energy range below the vacuum level, and the IP is the energy required to remove an electron from the highest occupied state to the vacuum level. This can be also measured by electrochemical methods such as Cyclic Voltammetry. CV is an electrochemical technique which measures the current that develops in an electrochemical cell under conditions where voltage is in excess of that predicted by the Nernst equation. CV is performed by cycling the potential of a working electrode, and measuring the resulting current.

A cyclic voltammogram is obtained by measuring the current at the working electrode during the potential scans. XPS is a technique that measures the kinetic energy of photoelectrons emitted from a sample upon absorption of X-ray photons. It provides information about the energy levels of the valence band and can also determine the ionization potential (IP) of a material. KPFM is a scanning probe microscopy technique that measures the surface potential of a sample. By mapping the surface potential, one can determine the position of the valence band and the ionization potential (IP).

For the present invention, the ionization energy (IP) of the various HTMs or compounds used as HTM as well as the organic/inorganic metal halide perovskite is determined by differential pulse voltammetry (DPV), affording an estimate of the corresponding Highest Occupied Molecular Orbital (HOMO) level of each HTM or compound used as HTM. According to standard protocol, the measurement and determination of the IP value is performed through the setting of voltammogram of the compound used as HTM in a 0.1 M n-$Bu_4NPF_6$/DCM solution, measured with glassy carbon working electrode, Pt wire reference and counter electrodes, and ferrocene/ferrocenium ($Fc/Fc^+$) as internal standard. Obtained potentials are converted to the normal hydrogen electrode (NHE) by addition of +0.64 V and -4.44 eV.

According to an embodiment, the succession of the layers in the multilayer structure of HTL is arranged such that the layer of the hole transport layer 5 in direct contact with the light-harvesting layer 4 is a layer comprising a donor material with an IP value being suitable for the energy match of the organic/inorganic metal halide perovskite and the interfacial hole injection. The donor material and the organic/inorganic metal halide perovskite can be isoenergetic. The IP value of the donor material is then equal to the IP value of the organic/inorganic metal halide perovskite, that is to say that the donor material has a HOMO energy level being equivalent to the energy level of the valence band of the organic/inorganic metal halide perovskite. A donor material with an IP value which is higher than the IP value of the organic/inorganic metal halide perovskite can be also a donor material with an IP value also being suitable for the energy match of perovskite and the interfacial hole injection. The donor material has an energy gap between the HOMO energy level of said donor material and the energy level of the valence band of the organic/inorganic metal halide perovskite being ≥0.05 eV and ≤0.60 eV. The donor material in the layer in direct contact with the light-harvesting layer has an IP being ≤-5.00 eV and ≥-5.60 eV, and equal to or higher than the IP value of the organic/inorganic metal halide perovskite. Said donor material has a HOMO energy level in the range of -5.00 eV to -5.60 eV or being ≤-5.00 eV and ≥-5.60 eV, and is higher than the valence band of the organic/inorganic metal halide perovskite, which may be ≤-5.00 eV and ≥-6.00 eV. The donor material has an IP value being suitable for the energy match of the organic/inorganic metal halide perovskite and the interfacial hole injection. Preferably, the IP value of donor material in the layer of HTL in direct contact with the light-harvesting layer is between -5,10 eV and -5,55 eV, most preferably between -5,30 eV and -5,50 eV.

According to a further embodiment concerning the arrangement of the HTMs in the HTL, the donor material of the layer in direct contact with the light-harvesting layer is selected from an ullazine derivative or a polymeric p-type semiconductor. Preferably, the donor material of the layer in direct contact with the light-harvesting layer is a ullazine derivative or a compound with an ullazine core. The ullazine derivative and polymeric p-type semiconductor have each an IP value being ≤-5.00 eV and ≥-5.60 eV, ≤-5.10 eV and ≥-5.55 eV, or preferably ≤-5.30 eV and ≥-5,50 eV, and most preferably ≤-5.30 eV and ≥-5,45 eV. Their IP values preferably match or have a better or close energy matching with the organic/inorganic metal halide perovskite and facilitate the interfacial hole injection.

In another embodiment, the layer of the hole transport layer 5 overlying the layer in direct contact with the light-harvesting layer 4 may comprise a hole transport material selected from a donor material having an IP value higher of 0.01 eV to 0.30 eV than the IP value of the donor material of the underlying layer in direct contact with the light-harvesting layer. Said layer may be a layer of HTL covering the layer of the HTL in direct contact with the light-harvesting layer, as in the case of layer 5b or one subsequent layer in electric contact with the layer of the HTL in direct contact with the light-harvesting layer, the layer being sandwiched between the layer of HTL covering the layer of the HTL in direct contact with the light-harvesting layer, or a successive layer thereof and the layer in direct contact with the back contact or the counter electrode or the back contact or the counter electrode itself.

The layer of the HTL underlying or in direct contact with the back contact or the counter electrode comprises a donor material or an acceptor material, preferably an acceptor material.

In a further embodiment, the layer of the hole transport layer in direct contact with or under the back contact 6 comprises an acceptor material, to which the electrons from the HTM in the underlying layer are transfered and has an IP value being ≤-7.00 eV and an electron affinity (EA) value ≥-4.8 eV or an EA value being higher than the IP value or HOMO level of the HTM, which may donor material, of the layer underlying the layer in direct contact with the back contact 6 or the counter electrode 6. The HTL of the device of invention may comprise one to three layers comprising an acceptor material.

According to another embodiment, the layer of the hole transport layer in direct contact with the back contact 6 or the counter electrode 6 may comprise a donor material having an IP value higher of 0.01 eV to 0.30 eV than the IP value of the donor material of the underlying layer. In this device configuration, the donor material in the layer in direct contact with the back contact or the counter electrode of the device replaces the acceptor as defined above.

The HTL is a multilayer structure, which comprises at least two layers or one or more layers comprising different organic semiconductors, of which contacts induce a process of electron transfer. In a particular embodiment, the HTL consists of two layers 5a,5b or of three layers 5a,5b,5c. The layer 5a comprises a donor material and the layer 5b comprises a donor material or an acceptor material. When the HTL is a bilayer (Figures 5A and 5B), the layer 5b may comprise a donor material or an acceptor material. In the bilayer stacking of HTMs, the layer 5b comprises a donor material with the proviso that the IP value of said donor material is higher of 0.01 eV to 0.30 eV than the IP value of the donor material of the layer 5a, which is in direct contact with the light-harvesting layer. The layer 5b of the bilayer underlies the back contact or the counter electrode of the optoelectronic device. When the HTL consists of three layers (Figure 5C), the layer 5a comprises a donor material, the layer 5b comprises a donor material and the layer 5c comprises an acceptor material.

The stacking of the layers in the HTL is arranged so as to promote charge transfer between the different interfaces, namely the donor-donor (DD) interface, the donor-acceptor (DA) interface and the donor-donor-acceptor (DDA) interface (Figure 3A). The electron transfer is induced by the contacts between the different organic semiconductors. The layers comprising a donor material or an acceptor material are configured on the basis of the IP values of each material to generate DD-, DA- and DDA-junctions, in which the additional electric field created by the contact between the different materials enhances and stresses the transport of holes in the dopant-free HTMs, resulting in a molecular orbitals

stretching (MOS). Regarding the DA interface, according to the charge transfer mechanism, the spin-electron transfer is followed by electron hopping to the electron orbitals of the acceptor ($\varepsilon$) or the formation of additional states in the gap ($\eta$) (Figure 3A). In the DA MOS junction, the electron transfers from the donor material of the layer 5a to the acceptor material of the layer 5b, which results in the formation in additional states in the acceptor material of layer 5b. In the DD interface, there is only electron hopping, which occurs from the HOMO level to the contact molecules as new orbitals, while there are two charge transfer processes in the DDA interface, one according to the DD MOS junction and the other according to the DA MOS junction. The DA MOS junction is a single homo-junction for the donor materials, while the DD MOS junction and the DDA MOS junction are heterojunctions the two layers of different contact donors. In the DD MOS junction, the electrons are transferred from the donor material of the layer 5b to the donor material of the layer 5a, i.e., the loss of electrons from the donor material of the layer 5b and the gain of electrons from the donor material of the layer 5a results in the formation of a heterojunction. In the DDA MOS junction, the loss of electrons from the donor material of layer 5b and the gain of electrons from the layer 5a results in the formation of a first heterojunction, and the transfer of electrons from the donor material of the layer 5b to the acceptor material of the layer 5c generating additional states in the acceptor gap results in the formation of a second heterojunction.

In particular, the layer 5a of the HTL being in direct contact with the light-harvesting layer comprises a HTM selected from a ullazine derivative or a compound of formula (I). The layer 5b of the HTL overlying the layer 5a comprises a HTM selected from a polymeric p-type semiconductor.

According to an embodiment, the donor material is, consists of or comprises a ullazine derivative being selected from a compound of formula I below:

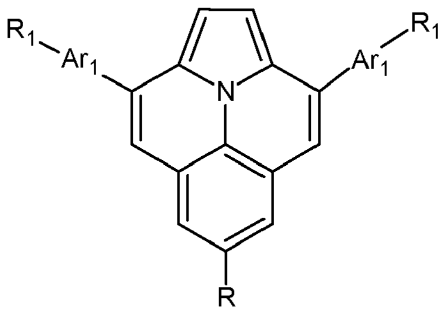

formula I,

wherein

- $Ar_1$ are identical or different, and selected from unsubstituted C6 aryl or unsubstituted C4-C5 heteroaryl comprising a heteroatom selected from O, S and N;
- $R_1$ are identical or different substituents, and selected from a moiety according to any one of formulae (Ia) and (Ib) below:

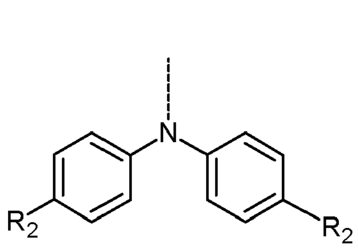

(Ia),

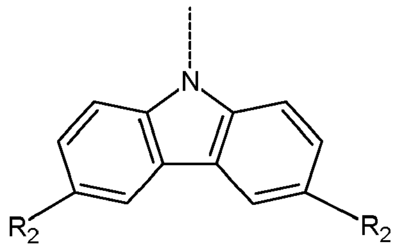

(Ib),

wherein $R_2$ are identical or different substituents and are selected from H, hydrocarbyl group comprising 1-20 carbon atoms, or hydrocarbyl group comprising 1 to 20 carbon atoms and 1 to 10 heteroatoms selected from O, S or N. wherein said hydrocarbyl groups, if said hydrocarbyl groups comprise 3 or more carbons, may be linear or branched and are unsubstituted or further substituted by halogen being selected from F, Cl, Br or I;
wherein the dotted line in the structures of formulae (Ia) and (Ib) represents a single bond by which substituent $R_1$ is linked to $Ar_1$; and

- R is selected from H, halogen selected from F, Cl, Br or I, moiety of formula (Ia), moiety of formula (Ib), C1-C15 alkyl group, C1-C15 heteroalkyl group, C2-C15 alkenyl group, or C2-C15 alkynyl group, wherein one or more heteroatoms are selected from N, S or O, wherein said alkyl, heteroalkyl, alkenyl and alkynyl group, if they comprise 3 or more

carbons, may be linear or branched and wherein alkyl, heteroalkyl, alkenyl, alkynyl groups are unsubstituted or further substituted by halogen being selected from F, Cl, Br or I.

According to a further embodiment, $Ar_1$ of the compound of formula I are identical and selected from unsubstituted C6 aryl or unsubstituted C4-C5 heteroaryl comprising a heteroatom selected from O, S and N, or preferably selected from unsubstituted C6 aryl.

In another embodiment, $R_1$ are identical substituents, and selected from a moiety according to any one of formulae (Ia) and (Ib), wherein $R_2$ are identical substituents and are selected from H, hydrocarbyl group comprising 1-10 carbon atoms, or hydrocarbyl group comprising 1 to 10 carbon atoms and 1 to 5 heteroatoms selected from O, S or N. wherein said hydrocarbyl groups, if said hydrocarbyl groups comprise 3 or more carbons, may be linear or branched and are unsubstituted or further substituted by halogen being selected from F, Cl, Br or I.

In a further embodiment, R is selected from H, a moiety according to any one of formulae (Ia) or (Ib), C1-C15 alkyl group, C1-C15 heteroalkyl group, wherein one or more heteroatoms are selected from N, S or O, C2-C15 alkenyl group, or C2-C15 alkynyl group, wherein said alkyl, heteroalkyl, alkenyl and alkynyl group, if they comprise 3 or more carbons, may be linear or branched and wherein alkyl, heteroalkyl, alkenyl, alkynyl groups are unsubstituted.

According to a further embodiment, the ullazine derivative is selected from a compound according to any one of formulae ULLA8, ULLA9, ULLA10, and ULLA11 (Figure 2A).

The ullazine derivatives, in particular the ullazine derivatives selected from a compound of formula (I) are encouraging donor materials as HTM due to the 16$\pi$-electrons in closed shell configuration. Such a compound may be used as dopant-free HTM in PSCs.

According to a second aspect, the invention concerns a hole transport material comprising an ullazine derivative selected from a compound of formula (I) as defined herein, preferably used as dopant-free HTM.

In another embodiment, the donor material being a polymeric p-type semiconductor is selected from a p-type semiconductor comprising a polymer having a HOMO energy level higher or an IP value higher of 0.01 eV to 0.30 eV than the IP value of the donor material of the underlying layer of the HTL, the IP value of said polymer being lower than the work function of the material of the back contact or the counter electrode. When the layer of the HTL in direct contact with the light-harvesting layer comprises a polymeric p-type semiconductor, said p-type semiconductor is selected from a polymer being isoenergetic with the organic/inorganic metal halide perovskite of the underlying layer or having an IP value being higher than the IP value of the organic/inorganic metal halide perovskite as recited herein. Preferably the polymeric p-type semiconductor is selected from Poly(3-hexylthiophene-2,5-diyl) (P3HT) and poly[5,5'-bis(2-butyloctyl)-(2,2'-bithiophene)-4,4'-dicarboxylate-alt-5,5'-2,2'-bithiophene] (PDCBT).

In a further embodiment, the acceptor material is selected from a material, in particular n-type material, transferring electrons to the HTM of the underlying layer in the HTL and has an IP value $\leq$-7.00 eV and an electron affinity (EA) value $\geq$-4.8 eV or an EA value being higher than the IP value of the donor material of the layer underlying the layer in direct contact with the back contact 6 or the counter electrode 6. The acceptor material is selected from [6,6]-phenyl-C61-butyric acid methyl ester (PCBM), buckminsterfullerene (C60), fullerene derivatives, perylene bisimide derivatives, naphthalimide derivatives, gelled ring type such as 2-[(2Z)-2-[[20-[[1-(Dicyanomethylidene)-3-oxoinden-2-ylidene]methyl]-12,12,24,24tetrakis(4-hexylphenyl)-5,9,17,21tetrathiaheptacyclo [13.9.0.03,13.04,11.06,10.016,23.018,22]tetracosa-1(15),2,4(11),6(10),7,13,16(23),18(22),19-nonaen-8-yl]methylidene]-3-oxoinden-1-ylidene] propanedinitrile ( ITIC ) , tris(pentafluorophenyl)borate (BCF), dimethylanilinium tetrakis(pentafluorophenyl) borate (N-PBA), or sodium tetrapentafluorophenyl borate (Na-PBA). The acceptor material is preferably selected from PCBM, C60 tris(pentafluorophenyl)borate (BCF), dimethylanilinium tetrakis(pentafluorophenyl) borate (N-PBA), or sodium tetrapentafluorophenyl borate (Na-PBA); most preferably tris(pentafluorophenyl)borate (BCF), dimethylanilinium tetrakis(pentafluorophenyl) borate (N-PBA), or sodium tetrapentafluorophenyl borate (Na-PBA).

The total thickness of the HTL comprising at least two layers of different HTMs is in the range from 40 nm to 1000 nm, from 40 to 200nm, from 40 to 70 nm, from 40 to 60 nm. The hole transporting layer comprises at least two films of different HTMs being free of pinholes and uniform, i.e. comprising one type of conformal structure. Such a type of films is provided by dynamic deposition method of the hole transporting material in solution on the underlying layer, the light-harvesting layer, an optional layer between the light-harvesting layer and the HTL, which may be a passivation layer, or a layer of a different HTM than the HTM of the underlying layer.

The optoelectronic or photovoltaic device of the invention further comprises a conducting support layer 1, a n-type semiconductor layer 2, and an electron transport layer 3 (ETL), characterized in that the conducting support layer 1 is covered by the n-type semiconductor 2 in contact with the electron transport layer 3 covered by the light-harvesting layer 4 in electric contact with the hole transport layer 5 being in electric contact with and/or coated or covered by the back contact 6 or the counter electrode 6.

For the purpose of the present specification, the expression "in electric contact with" or "in contact with" means that electrons or holes can get from one layer to the other layer with which it is in electric contact, at least in one direction. In

particular, considering the electron flow in the operating device exposed to electromagnetic radiation, layers through which electrons and/or holes are flowing are considered to be in electric contact. The expression "in electric contact with" does not necessarily mean that electrons and/or holes can freely move in any direction between the layers. The expression "in electric contact with" or "in contact with" does not necessarily mean to be directly in electric contact with or in direct contact with, but "in electric contact with" may also mean to be in contact through intermediate and/or optional layer, or optional and/or intermediate layer may be present there between.

The support layer 1 or conducting support layer is substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example. The conducting support layer provides the support layer the optoelectronic and/or photovoltaic device. The optoelectronic and/or electrochemical device may be built on said support layer. The support of the device may be also provided on the side of the back contact or counter electrode. In this case, the conductive support layer does not necessarily provide the support of the device, but may simply be or comprise a current collector, for example a metal foil.

The conducting support layer functions and/or comprises a current collector, collecting the current obtained from the device. The conducting support layer may comprise a material selected from indium doped tin oxide (ITO), fluorine doped tin oxide (FTO), $ZnO\text{-}Ga_2O_3$, $ZnO\text{-}Al_2O_3$, tin-oxide, antimony doped tin oxide (ATO), $SrGeO_3$ and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conducting support layers in accordance with the invention. The conducting support layer comprises a conducting transparent layer, which may be selected from conducting glass and from conducting plastic.

The n-type semiconductor 2 comprises a metal oxide layer. Preferably the n-type semiconductor comprises a compact metal oxide layer. The n-type semiconductor further comprises a mesoporous/nanoporous/nanostructured metal oxide being a surface-increasing scaffold structure provided onto the compact metal oxide layer. The n-type semiconductor comprises metal oxide particles selected from $SiO_2$, $TiO_2$, $SnO_2$, ZnO, $Zn_2SnO_4$, $Nb_2O_5$, $WO_3$, $BaTiO_3$ or $SrTiO_3$ or any combination thereof. The metal oxide particles of the compact layer and the metal oxide particles of the scaffold structure may be made of the same or different metal oxide described above.

The ETL 3 may be a monolayer or a multilayer structure comprising at least one electron transport material (ETM) selected from n-type metal oxides, which are in the form of crystalline layer or porous layers, and/or from n-type semiconducting polymer. If two or more layers are present, each layer of n-type metal oxide is of a different or identical type. The ETM may be selected from the n-type semiconductors as defined above. The ETM may comprise n-type organic semiconductor selected from PCBM-like C60 and fullerene derivatives selected from [6,6]-phenyl-C61-butyric acid methyl ester PCBM-like C60 or PCBM), 1,4,5,8,9,11-hexazatriphenylene-hexacarbonitrile (HAT-CN), (C60-Ih)[5,6]fullerene (C60), (C70-D5h)[5,6]fullerene (C70), [6,6]-Phenyl C71 butyric acid methyl ester (PC70BM), 2,9-dimethyl-4,7-diphenyl-1,10-phenanthroline (BCP), 1,3,5-tri(phenyl-2-benzimi-dazolyl)-benzene (TPBI), preferably PCBM, HAT-CN, C60, C70, PC70BM. PCBM-like C60 being a fullerene derivatives means [6,6]-phenyl C61 butyric acid methyl ester.

The total thickness of the ETL is in the range from 50 nm to 1000 nm, preferably from 50 to 600 nm. The thickness of the amorphous metal oxide layer is in the range from 10 nm to 30 nm.

The light-harvesting layer 4 comprises a film of an organic/inorganic metal halide perovskite or a perovskite. The perovskite or organic/inorganic metal halide perovskite film is prepared on the substrate forming part of the optoelectronic or photovoltaic device. Said substrate may comprise a conductive support and/or charge collector, n-type semiconductor with an optional scaffold structure and ETL.

The terminology "perovskite" is used herein equivalently to the terminology "organic/inorganic metal halide perovskite".

The perovskite or organic/inorganic metal halide perovskite is an organic-inorganic perovskite selected from a perovskite structure according to any one of formulae (IIa), (IIb), (IIc), or (IId), or an inorganic perovskite selected from a perovskite structure according to (IIe) below:

$$ABX_3 \qquad \text{(IIa)}$$

$$AA'BX_3 \qquad \text{(IIb)}$$

$$(A_1)_mAA'BX_3 \qquad \text{(IIc)}$$

$$(A_1)_mABX_3 \qquad \text{(IId)}$$

$$(A_1)_mBX_3 \qquad \text{(IIe)}$$

wherein,

- A and A' are organic, monovalent cations being independently selected from primary, secondary, tertiary or quaternary organic ammonium compounds, including N-containing heteroring and ring systems, A and A' having independently from 1 to 60 carbons and 1 to 20 heteroatoms;
- $A_1$ is an inorganic cation selected from $Li^+$, $Na^+$, $Tl^+$, $Cs^+$, $Rb^+$, $K^+$, $Ag^+$, $Cu^+$, $Au^+$ and m is an integer selected from 1 to 3, each $A_1$ if m >1 being different;
- B is selected from $Bi^{2+}$, $Cu^{2+}$, $Ni^{2+}$, $Co^{2+}$, Fe2+, $Mn^{2+}$, $Cr^{2+}$, $Pd^{2+}$, $Cd^{2+}$, $Ge^{2+}$, $Sn^{2+}$, $Pb^{2+}$, $Eu^{2+}$, $Yb^{2+}$, $[SniPb_{(1-i)}]^+$, $[Sn_jGe_{(1-j)}]^+$, and $[Pb_kGe_{(1-k)}]^+$, i, j and k being a number between 0.0 and 1.0, or an alloy thereof; and,
- X are independently selected from $Br^-$, $I^-$, $Cl^-$, $SCN^-$, $CN^-$, $NC^-$, $OCN^-$, $NCO^-$, $NCS^-$, $SeCN^-$, $TeCN^-$, $PF_6^-$, $BF_4^-$ or a combination thereof.

In particular, A and A' may be independently selected from $NH_4^+$, $CH_3NH_3^+$, $CH_3CH_2NH_3^+$, $HC(NH_2)_2^+$, $CH_3C(NH_2)_2^+$, $C_6H_5CH_2CH_2NH_3^+$, $C(NH_2)_3^+$, $CH_3(CH_2)_3NH_3^+$, $(CH_3)_2CHCH_2NH_3^+$, $(CH_3)_4N^+$, $CH_3NH_2^+$ or $(CH_3)_3NH^+$. In particular, M may be selected from $Bi^{2+}$, $Cu^{2+}$, $Ni^{2+}$, $Co^{2+}$, $Fe^{2+}$, $Mn^{2+}$, $Cr^{24}$, $Pd^{2+}$, $Cd^{2+}$, $Ge^{2+}$, $Sn^{2+}$, $Pb^{2+}$ or an alloy thereof. Preferably, X is independently selected from $Cl^-$, $Br^-$, and $I^-$ or a combination thereof.

The present HTL is provided directly on an as-prepared perovskite film or on a passivated surface of the as-prepared perovskite film, in which the passivating agent is selected from the group of Lewis bases comprising or consiting of alkylammonium, arylammonium, substituted aryl ethylammonium, alkyl amidinium, phenylpropanylammonium, and phenylpropanylamidinium, or the group of ionic liquids comprising or consisting of 1-Butyl-3-methylimidazolium hexafluorophosphate ($BMIM\text{-}PF_6$) and Butyl-1-méthyl-3-imidazolium tétrafluoroborate ($BMIM\ BF_4$).

The back contact 6 or the counter electrode 6 of the present device is provided on the HTL or an optional layer on the HTL. The back contact commonly comprises a catalytically active material, suitable to provide electrons and/or fill holes towards the inside of the device. The back contact may comprise one or more materials selected from Pt, Au, Ni, Cu, Ag, In, Ru, Pd, Rh, Ir, Os, C, conductive polymer and a combination of two or more of the aforementioned. Conductive polymers may be selected from polymers comprising polyaniline, polypyrrole, polythiophene, polybenzene, polyethylenedioxythiophene, polypropylenedioxy-thiophene, polyacetylene, and combinations of two or more of the aforementioned, for example.

The optoelectronic or photovoltaic device may be selected from an organic photovoltaic device, a photovoltaic solid state device, an organic/inorganic metal halide perovskite photovoltaic device, an organic/inorganic metal halide perovskite solar cell, a solid state solar cell, a n-i-p perovskite solar cell, a phototransistor or LED (light-emitting diode).

The present invention will now be illustrated by way of examples. These examples do not limit the scope of this invention, which is defined by the appended claims.

Examples:

**Example 1: Synthesis of ullazine derivatives ULLAs 8 to 11**

The ullazine derivatives were synthesized according to the scheme below:

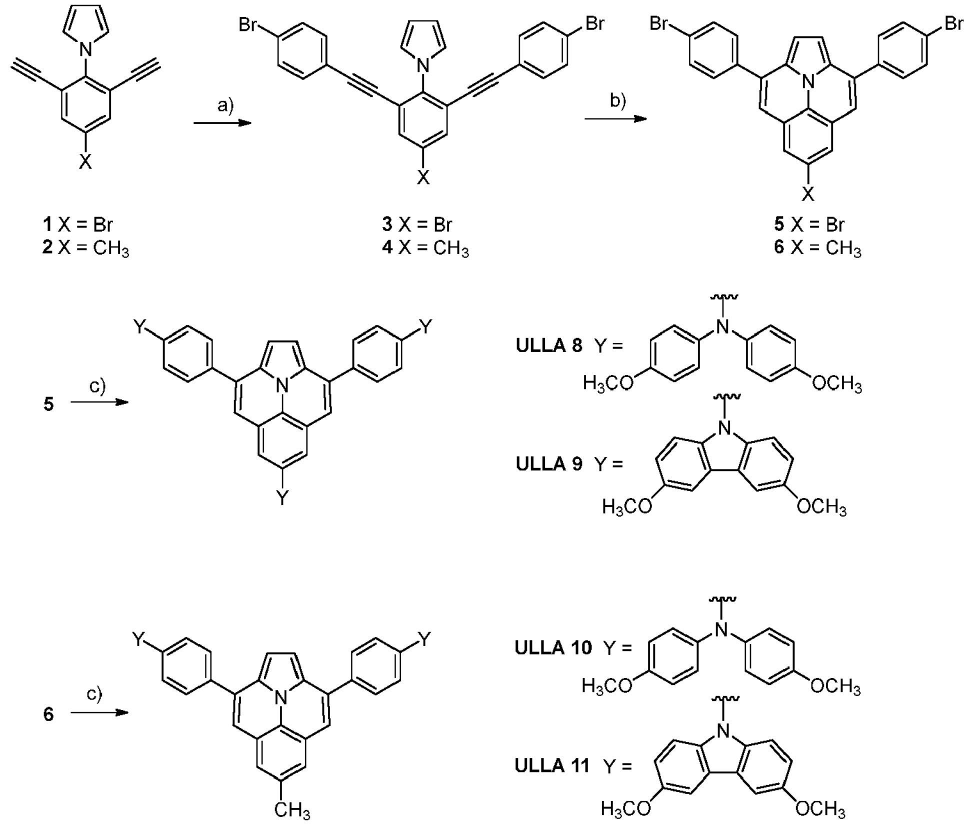


**1** X = Br
**2** X = $CH_3$
**3** X = Br
**4** X = $CH_3$
**5** X = Br
**6** X = $CH_3$
**5**
**ULLA 8** Y =
**ULLA 9** Y =
**6**
**ULLA 10** Y =
**ULLA 11** Y =

,

wherein the conditions of the reactions steps respectively are a) 4-bromoiodobenzene, $Pd(Ph_3)_4$, CuI, $Et_3N$, THF, rt. Yield = 86% (3) or 80% (4); b) $InCl_3$, toluene, 110°C; then $InCl_3$, 1,2-dichlorobenzene, 180°C. Yield = 73% (5) or 79% (6); c) bis(4-methoxyphenyl)amine or 3,6-dimethoxy-9*H*-carbazole, $Pd_2(dba)_3$, tri-tert-butylphosphine, $NaO^tBu$, 115°C. Yield = 67% (ULLA 8), 76% (ULLA 9), 73% (ULLA 10), 90% (ULLA 11). The readily available pyrrole derivatives 1 and 2 (pyrrole derivative 1: 1-(4-Bromo-2,6-diethynylphenyl)-1*H*-pyrrole, pyrrole derivative 2 1-(4-methyl-2,6-diethynylphenyl)-1*H*-pyrrole) were used as starting materials for the three-steps synthesis of ULLA 8-9 and ULLA 10-11, respectively. Sonogashira coupling of these precursors with 4-bromoiodobenzene was followed by double $InCl_3$. The enhanced cycloaromatization led to the brominated ullazines 5 and 6 that smoothly underwent exhaustive amination under Buchwald-Hartwig conditions to give the desired compounds.

*Synthesis of 4,4'-{6-[Bis(4-methoxyphenyl)amino]indolizino[6,5,4,3-ija]quinoline-3,9-diyl} bis[N,N-bis(4-methoxyphenyl)aniline] corresponding to ULLA 8*

A flame-dried Schlenk tube was charged under nitrogen with ullazine (5) (348 mg, 0.60 mmol), bis(4-methoxyphenyl)amine (151 mg, 1.97 mmol), $Pd_2(dba)_3$ (55 mg, 0.06 mmol) and $NaO^tBu$ (262 mg, 2.73 mmol). Anhydrous toluene (10 mL) was added and the mixture was ventilated at low temperature (x 3 times); tri-tert-butylphosphine solution 1.0 M in toluene (120 $\mu$L, 0.12 mmol) was added in one portion and the final mixture was vigorously stirred at 115°C for 24h. After cooling to RT the mixture was diluted with DCM (100 mL) and filtered on a Celite pad. The solid was then washed with DCM until the washings were colourless. The combined liquid phase was washed with water (3 x 50 mL). The organic phase was dried over $MgSO_4$ and the residue obtained after evaporation of the solvent was purified by gravimetric column chromatography (silica gel, hexane/AcOEt 7:3). The fractions containing the desired product were collected and evaporated under reduced pressure. The solid obtained was washed with cold MeOH and filtered off to afford the title compound (412 mg, 67% yield) as a yellow solid.

$^1H$ NMR (400 MHz, $CD_2Cl_2$) $\delta$ 7.57 (d, *J* = 8.6 Hz, 4H), 7.12 (d, *J* = 8.9 Hz, 8H), 7.08-7.04 (m, 8H), 7.00-6.97 (m, 6H), 6.87 (d, *J*= 8.9 Hz, 8H), 6.83 (d, *J*= 8.9 Hz, 4H), 3.79 (s, 12H), 3.78 (s, 6H). $^{13}C$ NMR (101 MHz, $CD_2Cl_2$) $\delta$ 156.84, 156.11, 149.55, 145.84, 142.37, 141.16, 133.76, 130.62, 129.14, 128.65, 127.51, 127.38, 126.81, 126.41, 120.31, 118.37, 115.27, 115.12, 113.56, 106.50, 56.01 (2 isochronous $OCH_3$). Elemental analysis calcd (%) for $C_{68}H_{56}N_4O_6$: C 79.67, H 5.51, N 5.46; found: C 79.64, H 5.56, N 5.41.

*Synthesis of 6-(3,6-Dimethoxy-9H-carbazol-9-yl)-3,9-bis[4-(3, 6-dimethoxy-9H-carbazol-9-yl)phenyl]indolizino[6,5,4,3-ija]quinoline corresponding to ULLA 9*

A flame-dried Schlenk tube was charged under nitrogen with ullazine (5) (319 mg, 0.55 mmol), bis(4-methoxyphenyl)amine (414 mg, 1.82 mmol), $Pd_2(dba)_3$ (55 mg, 0.06 mmol) and $NaO^tBu$ (231 mg, 2.40 mmol). Anhydrous toluene (12 mL) was added and the mixture was deareated at low temperature ($\times$ 3 times); tri-*tert*-butylphosphine solution 1.0 M in toluene (120 $\mu$L, 0.12 mmol) was added in one portion and the final mixture was vigorously stirred at 115°C for 16h. After cooling to RT the mixture was diluted with DCM (200 mL) and filtered on a Celite pad. The solid was then washed with DCM until the washings were colourless. The combined liquid phase was washed with water (3 $\times$ 50 mL). The organic phase was dried over $MgSO_4$ and the residue obtained after evaporation of the solvent was washed with hot MeOH and next purified by gravimetric column chromatography (silica gel, DCM). The fractions containing the desired product were collected and evaporated under reduced pressure. The solid obtained was washed with cold $Et_2O$ and filtered off to afford the title compound (426 mg, 76% yield) as a yellow solid.

$^1H$ NMR (400 MHz, $CDCl_3$) $\delta$ 8.07 (d, *J*= 8.3 Hz, 4H), 7.76 (d, *J*= 8.3 Hz, 4H), 7.72 (s, 2H), 7.62 (d, *J*= 2.4 Hz, 2H), 7.59 (d, *J*= 2.3 Hz, 4H), 7.49 (d, *J*= 8.90, 4H), 7.47 - 7.43 (m, 4H), 7.34 (s, 2H), 7.09 (dd, *J* = 8.9, 2.2 Hz, 6H), 3.99 (s, 6H), 3.98 (s, 12H).$^{13}C$ NMR (101 MHz, $CDCl_3$) $\delta$ 154.37, 154.24, 138.71, 137.04, 136.92, 136.29, 135.72, 134.42, 133.81, 131.56, 129.80, 127.32, 127.01, 124.01, 123.74, 119.39, 117.85, 115.46 (2 isochronous aromatic C-H), 110.96, 110.84, 107.20, 103.13 (2 isochronous aromatic C-H), 56.34, 56.30. Elemental analysis calcd (%) for $C_{68}H_{50}N_4O_6$: C 80.14, H 4.95, N 5.50; found: C 80.18, H 5.00, N 5.47.

*Synthesis of 4,4'-(6-Methylindolizino[6,5,4,3-ija]quinoline-3,9-diyl)bis[N,N-bis(4-methoxyphenyl)aniline] corresponding to ULLA 10*

A flame-dried Schlenk tube was charged under nitrogen with ullazine (6) (200 mg, 0.39 mmol), bis(4-methoxyphenyl)amine (295 mg, 1.29 mmol), $Pd_2(dba)_3$ (36 mg, 0.039 mmol) and $NaO^tBu$ (170 mg, 1.77 mmol). Anhydrous toluene (15 mL) was added and the mixture was deareated at low temperature (x 3 times); tri-*tert*-butylphosphine solution 1.0 M in toluene (80 $\mu$L, 0.080 mmol) was added in one portion and the final mixture was vigorously stirred at 115°C for 24h. All volatiles were then removed at reduced pressure; the residue was taken up in AcOEt (150 mL) and the organic phase was washed with water (3 $\times$ 50 mL). The organic phase was dried over $MgSO_4$ and the residue obtained after evaporation of the solvent was purified by gravimetric column chromatography (silica gel, hexane/AcOEt 9:1) to afford the title compound (232 mg, 73% yield) as a yellow solid. $^1H$ NMR (400 MHz, $CDCl_3$) $\delta$ 7.65 - 7.53 (m, 4H), 7.22 (br s, 2H), 7.17 - 7.11 (m, 8H), 7.10 (s, 2H), 7.06 (s, 2H), 7.05 - 7.00 (m, 4H), 6.91 - 6.81 (m, 8H), 3.80 (s, 12H), 2.51 (br s, 3H). $^{13}C$ NMR (101 MHz, $CDCl_3$) $\delta$ 156.15, 148.93, 140.88, 133.42, 133.18, 130.70, 130.61, 128.79, 126.97, 126.67, 125.99, 120.19, 119.58, 118.24, 114.89, 105.86, 55.62, 21.89. Elemental analysis calcd (%) for $C_{55}H_{45}N_3O_4$: C 81,36, H 5.59, N 5.18; found: C 81.30, H 5.63, N 5.14.

*Synthesis of 3,9-Bis[4-(3,6-dimethoxy-9H-carbazol-9-yl)phenyl]-6-methylindolizino [6,5,4,3-ija]quinoline corresponding to ULLA 11*

A flame-dried Schlenk tube was charged under nitrogen with ullazine (6) (300 mg, 0.58 mmol), 3,6-dimethoxy-9H-carbazole (435 mg, 1.91 mmol), $Pd_2(dba)_3$ (36 mg, 0.039 mmol) and $NaO^tBu$ (252 mg, 2.63 mmol). Anhydrous toluene (15 mL) was added and the mixture was deareated at low temperature (x 3 times); tri-tert-butylphosphine solution 1.0 M in toluene (80 $\mu$L, 0.080 mmol) was added in one portion and the final mixture was vigorously stirred at 115°C for 24h. All volatiles were then removed at reduced pressure; the residue was taken up in AcOEt (150 mL). The organic phase was washed with water (3 $\times$ 50 mL) and dried over $MgSO_4$. After evaporation of the solvent, the residue was redissolved in DCM (50 mL) and treated with EtOH (50 mL). The resulting precipitate was filtered off and redissolved at room temperature in a minimal amount of toluene (5 mL); EtOH was added dropwise to the solution until a persistent opalescence was noted. The mixture was left standing overnight at room temperature. The precipitate obtained was collected by filtration to afford the title compound (420 mg, 90% yield) as a yellow solid.

$^1H$ NMR (400 MHz, $CDCl_3$) $\delta$ 8.01 (d, *J* = 8.5 Hz, 4H), 7.72 (d, *J* = 8.4 Hz, 4H), 7.59 (d, *J* = 2.5 Hz, 4H), 7.49 (d, *J* = 8.8 Hz, 4H), 7.38 (s, 2H), 7.29 (s, 2H), 7.19 (s, 2H), 7.09 (dd, *J*= 8.9, 2.5 Hz, 4H), 3.98 (s, 12H), 2.60 (s, 3H); $^{13}C$ NMR (101 MHz, $CDCl_3$) $\delta$ 154.32, 138.35, 137.37, 136.32, 133.85, 132.76, 131.29, 129.66, 126.89, 126.63, 125.85, 123.95, 120.57, 119.61, 115.42, 110.98, 106.07, 103.10, 56.29, 21.98. Elemental analysis calcd (%) for $C_{55}H_{41}N_3O_4$: C 81.76, H 5.12, N 5.20; found: C 81.79, H 5.13, N 5.17.

**Example 2: Electric properties of the HTMs**

*Characterizations*

Current-voltage characteristics were recorded by applying an external potential bias to the cell while recording the generated photocurrent with a digital source meter (Keithley Model 2400).

The light source was a 450 W Xenon lamp (Oriel) equipped with a SchottK113 Tempax sunlight filter (Praezisions Glas & Optik GmbH) to match the emission spectrum of the lamp to the AM1.5G standard. Before each measurement, the exact light intensity was determined using a calibrated Si reference diode equipped with an infrared cutoff filter (KG3, Schott). The cells were masked with an active area of 0.09 $cm^2$. IPCE spectra were recorded as a function of wavelength under a constant white light bias of 10 mW $cm^2$ supplied by an array of white light-emitting diodes. The excitation beam from a 300 W xenon lamp (ILC Technology) was focused through a Gemini-180 double monochromator (Jobin Yvon Ltd) and chopped at 2 Hz. The signal was recorded using a Model SR830 DSP Lock-In Amplifier (Stanford Research Systems). For the DPV, the HTMs were dissolved in 0.1 M *n*-$Bu_4NPF_6$/DCM solution, measured with a glassy carbon working electrode, Pt wire reference and counter electrodes, ferrocene/ferrocenium ($Fc/Fc^+$) as internal standard. Potentials were converted to the normal hydrogen electrode (NHE) by the addition of +0.64 V and -4.44 eV. Contact angle measurements were done with the help of the Drop Shape Analyzer-DSA30s instrument and analyzed with the help of the Krüss "Advance" software. The femtosecond transient absorption (fs-TA) spectra were performed using a femtosecond regenerative amplified Ti: sapphire laser system (Spectra-Physics, Spitfire-Pro) and an automated data acquisition system (ultrafast systems, Helios Fire). The hole mobility performed by XTOF measurement. Sample preparation for XTOF measurement - drop casting, solvent - THF (ULLA8, ULLA9, ULLA10) or CB (ULLA11), on glass substrates with Al coating. The corona charging used to create electric field. Charge carriers were generated at the layer surface by illumination with pulses of UV flash (xenon lamp with UV filter, pulse duration 1 μs). The layer surface potential decrease as a result of pulse illumination was about 10 % of initial potential and so was ensured small charge mode in XTOF measurement. The speed of the surface potential decreases $dU/dt$, which is equivalent to a current in widely known TOF technique, was measured with the capacitance probe deposited over the sample. The transit time $t_t$ was determined by the kink on the curve of the $dU/dt$ transients in double logarithmic plot. The drift mobility was calculated by the formula $\mu = d^2/U_0 t_t$, where d is the layer thickness and U0 is the surface potential at the moment of illumination. The hole mobility results are shown in standard plot for organic compounds. In all the cases investigated, the mobility is approximated by the formula $\mu = \mu_0 \exp(\alpha\sqrt{E})$, where $\mu_0$ is the zero-field mobility, $\alpha$ is field dependence parameter, and E is electric field strength.

*Electric properties*

Organic semiconductors (Figures 2A and 2B) with different electronic properties were combined to enhance charge transfer upon molecular contact. The ullazine derivatives ULLA 8-11 (ULLAs) are promising donor materials for the HTLs of PSCs due to the 16 $\pi$-electrons in their closed shell configuration, and they were selected as the donor type D1 for the charge transfer. The ionization energy (IP) of these molecules was determined by differential pulse voltammetry (DPV), affording an estimate of the corresponding highest occupied molecular orbital (HOMO) level. Experimental IPs of -5.40 eV (ULLA8), -5.37 eV (ULLA9), -5.44 eV (ULLA10) and -5.31 eV (ULLA11) were measured and are well-matched with the energy of perovskite and suitable for the interfacial hole injection. The HOMO level of LTLLA8, ULLA9, ULLA10 and ULLA11 respectively are 5.40 eV, 5.37 eV, 5.44 eV and 5.31 eV.

The hole mobility values for ULLA 8-11 were determined by xerographic time of flight (XTOF) experiments (Figure 4A). They are in the order of magnitude of $10^{-6}$ to $10^{-5}$ $cm^2/Vs$, which highlights the transportation obstacles within the bulk HTMs layers (Table 1).

*Table 1. The Hole mobility of for the synthetic isomer ULLAs*

| Devices | $\mu_0$ ($cm^2/V \cdot s$) | $\mu^{(1)}$ ($cm^2/V \cdot s$) | $\alpha^{(2)}$ $(cm/V)^{0.5}$ |
|---|---|---|---|
| ULLA8 | $\sim 2 \cdot 10^{-6}$ | $1.1.10^{-5}$ | ~0.0021 |
| ULLA9 | $7 \cdot 10^{-8}$ | $1.9 \cdot 10^{-5}$ | 0.0071 |
| ULLA10 | $\sim 3.10^{-7}$ | $0.8 \cdot 10^{-5}$ | ~0.0043 |

(continued)

| Devices | $\mu_0$ (cm²/V·s) | $\mu^{(1)}$ (cm²/V·s) | $\alpha^{(2)}$ (cm/V)$^{0.5}$ |
|---|---|---|---|
| ULLA11 | $1.3\cdot10^{-7}$ | $1.2\cdot10^{-5}$ | 0.0056 |

(1) at $E$=$6.4\cdot10^5$ V/cm;

(2) $\alpha$ is field dependence parameter from equation $\mu = \mu_0 \exp(\alpha\sqrt{E})$.

It is worth noting that the planar 3,6-dimethoxy-9H-carbazole substituents present in ULLA9 and ULLA11 have a positive effect on the hole mobility compared to twisted bis(4-methoxyphenyl)amine substituents (ULLA8 and ULLA 10). The presence of a nitrogen substituent at the 6-position of the ullazine core (ULLA8 and ULLA9) instead of a methyl group (ULLA10 and ULLA11) also increases the hole mobility of these HTMs.

Poly(3-hexylthiophene-2,5-diyl) (P3HT) and poly[5,5'-bis(2-butyloctyl)-(2,2'-bithiophene)-4,4'-dicarboxylate-alt-5,5'-2,2'-bithiophene] (PDCBT) are popular polymeric dopant free (DF) HTMs for stable PSCs and were introduced as the donor type D2. Their IPs are -5.3 eV (PDCBT) and -5.14 eV (P3HT). (Figure 2B)

The organic Lewis acid tris(pentafluorophenyl)borate (BCF) and the ionic derivatives dimethylanilinium tetrakis(pentafluorophenyl) borate (N-PBA) and sodium tetrapentafluorophenyl borate (Na-PBA), which exhibit electron affinities (EAs) higher than 4.8 eV and IPs lower than -7 eV, were employed as the acceptors (Figure 2B).

**Example 3: Stacking of layers of HTMs**

*Theorical charge transfer mechanism in MOS junction*

The molecules pairs energy difference of charge transfer can simply consider by two microstates: $\Delta E = -\Delta E_{off} + V_C + \Delta V_E$, where $\Delta E_{off} = EA_M - IP_M$ or $\Delta E_{off} = |IP_{M1} - IP_{M2}|$are the molecules specific orbital energy difference, and Vc $=-e^2/4\pi\varepsilon\varepsilon_0 r$ is the electrostatic interaction energy between within the molecule pairs, r is the distance between the molecules, $\varepsilon$ is electric constant, $\varepsilon_0$ is relative material permittivity, and e is the elementary charge. $\Delta V_E$ is the electrostatic environmental potential for the complicated surface modification system. An environmental charge would influence the electrostatic potential, as the molecules units are not single. According to Casalegno et al. (J. Chem. Phys. (2010). 132, 094705), the environmental electrostatic potential ($\Delta V_E$) can be expressed by:

$$\Delta V_E = \frac{-e^2}{4\pi\varepsilon\varepsilon_0 r}\left[\sum_{\alpha}(r_\alpha - r_S)^{-1} - (r_\alpha - r_M)^{-1}\sum_{\beta}(r_\beta - r_S)^{-1} - (r_\beta - r_M)^{-1}\right]$$

Where, the $\alpha$ and $\beta$ are the positive and negative charges in the environment, $r_\alpha$, $r_\beta$, $r_S$, $r_M$ are the positions of positive and negative charges in the environment and the positions of the semiconductor units and surface molecule, respectively. As the energy difference of the molecules pairs, the electron or the hole will be hopping between the two sites, and the hopping rate of an electron or hole from site *i* to j, $W_{ij}$ is described by the Miller-Abraham (MA) equation (Miller, A. & Abrahams, E. Phys. Rev. (1960) 120, 745-755):

$$W_{ij} = v_0 e^{(-2r_{ij}/b)} e^{\left[-\frac{|E_j - E_i| + (E_j - E_i)}{k_B T}\right]}$$

Where $E_j$ and Ei is energies of the final and initial state, $v_0$ is the attempt-to-escape frequency, b is the localization radius of a charge carrier, $k_B$ is Boltzmann constant, T is the temperature. Thus, a change in the energy levels and the potential difference between molecules will change the surface electron or hole hoping, resulting in different surface electron and hole concentrations of the organic semiconductor.

According to the above demonstrated charge transfer mechanism, the spin-electron will transfer followed by the electron hopping to the electron orbitals of acceptor ($\varepsilon$) or forming the additional states within the gap ($\eta$) for the DA and DD interfaces (Figure 3A).

Figure 3B illustrates the electron and hole orbitals stretching of the MOS by the electron transfer. For the DA-MOS (I), $S_{0E}$ and $S_{0H}$ are the pristine breadth of electron and hole orbitals of HTMs (left side). When the acceptor contact at the right side of HTMs, the breadth of stretch electron orbitals (SEO) will expand from $S_{XE}$ to $S_{AE}$ by the $\varepsilon$ or $\eta$ electron transfer

process (according to the final equation of MOS theory as described herein). However, the breadth of stretch hole orbitals (SHO) shrink from $S_{XH}$ to $S_{AH}$, and finally form a shrinking SHO from left side to right side, assist the hole transportation and reduced the drifting freedom of hole within bulk HTMs. In addition, the gradually varied up band blending of HOMO edge is classical promote hole transfer of HTMs. Inversely, the SEO exhibits an expanding from left side to right side of HTMs, it will resist the electron transportation. For DD-MOS (II), the electron transfers from HTM D2 to HTM D1, which loss the electron at D2 and gain electron at D1 and forming heterojunction by two layers. Thus, making the breadth of SHO shrinking, but more expanding of SEO at the left side, which contributed by the $\eta$ process. For DDA-MOS (III), it further shrinks the SHO orbitals and expanding the SEO orbitals at the right side on the basis of DD-MOS and DA-MOS, which will be the best junction for the hole transportations among the three types of MOS.

*Experimental charge transfer mechanism in MOS junction*

ULLAs (D1 type donors), PDCBT and P3HT (D2 type donors), BCF, Na-PBA and NPBA (acceptors) were combined according to their IPs to give well-matched DA-MOS, DD-MOS and DDA-MOS. In particular, the DA-MOS PDCBT/BCF (PB) and the DD-MOS ULLA9/PDCBT (9P) were selected to probe the orbitals stretching by the molecules contact.

As shown in Figure 4B, the hole orbital edge of PDCBT shrinks 1.15 eV towards high energy level upon pairing with BCF (DA-MOS), while the electron orbital edge of PDCBT expands 1.25 eV towards the vacuum energy level (Figure 4B right) as calculated by Density Functional Theory (DFT). These results are consistent with the final equation described herein and corroborate the orbitals stretching hypothesis. After accepting the electron from PDCBT, BCF exhibits inverse orbitals stretching, i.e. the hole orbital expands, but the electron orbital shrinks.

The orbital stretching of the DD-MOS 9P has been studied. PDCBT is $\pi$-stacked on the ULLA9 core, which would favor the hole transfer at the contact interface. However, the stretching of hole orbital and electron orbital for PDCBT are limited, with the hole orbital expanding 0.14 eV and the electron orbital shrinking 0.09 eV. For ULLA9, the stretching upon pairing is much higher with 1.12 eV expansion for the hole orbitals, and 1.1 eV shrinkage for the electron orbitals. This indicates the occurrence of orbitals stretching for the DD pair (Figure 3B, type II) *via* the $\eta$ electron transfer process, even with a faint expansion of the stretched hole orbitals of PDCBT at the contact side of DD-MOS. This particular phenomenon may originate from the similar IPs of PDCBT (-5.3 eV) and ULLA9 (-5.37 eV).

Femtosecond transient absorption (fs-TA) spectra were measured for Glass/perovskite/ULLA9 and Glass/perovskite/DDA-MOS (9PB) stacks to compare the interfacial carrier dynamics under excited state. The bird's eye graphs of the $\Delta$OD were drawn as a function of wavelength and delay time, as well as the key $\Delta$OD for a series of delay times ranging from 1 to 5000 ps. It is evident from $\Delta$OD that in both cases a positive excited-state absorption (ESA) band appears below 720 nm and a strong negative ground-state bleaching (GSB) band appears at about 768 nm. In the whole interval of investigated delay times, the DDA-MOS (9PB) based stack exhibits GSB peaks of higher intensity compared to the ULLA9 based stack. This may attribute to a reduced interface carrier recombination by the expansion of the stretched electron orbitals at the carriers transfer path, although the higher quality of the perovskite film may also play a role. According to the graphic representing the time evolution of the GSB peaks for both stacks, the quenching of excited-state carriers is fitted by a double exponential function where the ultrafast time decay scale <1000 ps indicates the effective quenching of interfacial carrier injection and transportations. The stack containing DDA-MOS (9PB) exhibited faster decay of the GSB peak and decreased from 108.78 ps to 45.76 ps, which can be ascribed to the shrinking of the stretched hole orbital at the hole transfer path.

**Example 4: Photovoltaic properties of PSCs with MOS junctions**

*Device fabrication*

The chemically etched FTO glass (Nippon Sheet Glass) was cleaned with a detergent solution, deionized water, acetone, and isopropanol. For the compact $TiO_2$ (c-$TiO_2$) layer, TAA solution in ethanol (0.2 mL of TAA in 6 mL of anhydrous isopropanol) was sprayed at 450°C, and further heating for 1 h at 450°C was done. Mesoporous $TiO_2$ paste was diluted with ethanol with a ratio of 1:10 and coated on top of the c-$TiO_2$ substrate at a speed of 3000 rpm for 20 s and finally heated at 500°C for 20 min. The tin oxide layer was formed by dissolving $SnCl_4$ in deionized water at a concentration of 12 uL/mL and spin-coated on the mesoporous $TiO_2$ layer at a speed of 3000 rpm for 20 s, and finally heated at 190°C for 60 min. Perovskite precursors solutions in DMSO/DMF 1:4 v/v (CsI: 11.78 mg; MAI: 11.12 mg; FAI: 228.72 mg; $PbI_2$: 709.95 mg; MACl: 18.90 mg) were successively spin-coated on the substrates at 1000 rpm for 10 s and 5000 rpm for 30 s consecutively. 1 mL of diethyl ether was dropped in 10 s at 5000 rpm. Perovskite films were annealed at 150°C for 10 min. The PEAI solution was prepared by 7 mg/mL in IPA, and then spin-coating on perovskite film at 4000 rpm for 30s. The ULLA HTMs solutions (D1) were prepared by concentration of 20 mg/mL in 1 mL chlorobenzene. The PDCBT and P3HT solutions (D2) prepared by the concentration of 10 mg/mL in CB. The BCF, Na-PBA and N-PBA acceptors (A) were

prepared by the concentration of 5 mg/mL in IPA. All the HTMs and the acceptors were dynamic spin-coating on the substrates at 3000 rpm for 30s. Finally, followed by the deposition of the 70 nm-thick Au electrode.

The module composed of eight-strip cells connected in series using P1, P2, P3 type interconnects. The laser structuring of all three scribes (P1, P2, P3) were made with the same near infrared 1064 nm, 20W laser (Trotec). For fabrication of solar modules, 6.5 cm × 7 cm FTO substrates were patterned by a laser with a scribing width of 40 μm (Speed 300 mm/s, frequency 65 kHz, pulse duration: 120 ns, power 60%). All the ETLs, perovskite layers and HTMs fabricated same to small cells. Next, the C-$TiO_2$/m-$TiO_2$/$SnO_2$/Perovskite/PEAI/HTMs layers were scribed by a laser a scribing width of 400 μm (multiple parallel scribes with 50 microns spacing, speed 1000 mm/s, pulse duration 120 ns, frequency 65 kHz, power 15%). Finally, a gold electrode was deposited by thermal evaporation, and gold layers were scribed by a laser with a scribing width of 50 μm (speed 1000 mm/s, pulse duration 120 ns, frequency 65kHz, power 15%).

*Computational details*

To simulate the stacking process of HTM molecules on the polymeric chain of PDCBT and on the surface of $FAPbI_3$ perovskite molecular dynamics simulations, employing TB Hamiltonian along with Grimme's D3 correction, were performed for several tenth of picoseconds, using the implementation in CP2K code. The timestep equaled 1 fs and the temperature was maintained at 343.15 K using velocity rescaling algorithm with the tolerance of 30 K. The geometrical parameters of HTM deposited either on top of perovskite surface or on PDCBT were analyzed on an equilibrated trajectory of several picoseconds. The structural model of PDCBT comprised three monomer units. The surface of $FAPbI_3$ perovskite was represented by a $PbI_2$-terminated (001) slab to account for possible interactions between $Pb^{2+}$ cations and the HTM molecules. Two HTM molecules in each case were initially deposited on top of polymer chain and perovskite surface to analyze both the intermolecular stacking of HTM molecules and their interactions with the PDCBT and perovskite, respectively. To reach the stable conformations of the system, previously described procedure was employed. The structural models are visualized with VMD code. The stretching of orbitals were given by CASTEP package under the Generalized Gradient Approximation-Perdew Burke Emzerh (GGA-PBE) exchange correlation functional.

*Photovoltaic properties of PSCs*

The photovoltaic (PV) properties of n-i-p PSCs with configuration FTO/C-$TiO_2$/m-$TiO_2$/$SnO_2$/3D Perovskite/-PEAI/DF-HTM/Au, in which the DF-HTM was either ULLA8-11, P3HT or PDCBT, were studied and compared with those of PSCs having the same configuration, but wherein the hole transport was ensured by DD-, DA-, and DDA-MOS junctions. Polymer P3HT and PDCBT have relative high hole mobility under dopant-free conditions. However, PSCs fabricated with these two HTMs exhibited modest PCEs (just above 16%) and $V_{oc}$ lower than 1 V (Tables 2 and 3) due to the mismatch of energy level with the Au electrode (-5.1 eV) and the valence band of the perovskite layer (-5.4 to -5.5 eV).

*Table 2 The PV parameters of devices based on DA-MOS construct by P3HT and various acceptors*

| Devices | $J_{sc}$ [mA cm$^{-2}$] | $V_{oc}$ [V] | FF | PCE [%] |
|---|---|---|---|---|
| P3HT | 24.03 | 0.975 | 0.703 | 16.47 |
| P3HT/BCF | 24.76 | 1.061 | 0.767 | 20.14 |
| P3HT/Na-PBA | 24.64 | 1.056 | 0.757 | 19.69 |
| P3HT/N-PBA | 24.46 | 1.041 | 0.745 | 18.96 |

*Table 3 The PV parameters of devices based on DF PDCBT and the DA-MOS by N-PBA*

| Devices | $J_{sc}$ [mA cm$^{-2}$] | $V_{oc}$ [V] | FF | PCE [%] |
|---|---|---|---|---|
| PDCBT | 23.34 | 0.953 | 0.725 | 16.12 |
| PDCBT/N-PBA 3mg | 24.16 | 1.03 | 0.758 | 18.86 |
| PDCBT/N-PBA 5 mg | 24.54 | 1.061 | 0.777 | 20.23 |
| PDCBT/N-PBA 8 mg | 24.41 | 1.046 | 0.765 | 19.53 |

*Table 4 The PV parameters of devices based on DF- ULLAs.*

| Devices | $J_{sc}$ [mA cm$^{-2}$] | $V_{oc}$ [V] | FF | PCE [%] |
|---|---|---|---|---|
| ULLA8 | 23.25 | 0.985 | 0.750 | 17.17 |
| ULLA9 | 23.50 | 1.002 | 0.754 | 17.75 |

(continued)

| Devices | $J_{sc}$ [mA cm$^{-2}$] | $V_{oc}$ [V] | FF | PCE [%] |
|---|---|---|---|---|
| ULLA10 | 22.99 | 0.954 | 0.721 | 15.81 |
| ULLA11 | 23.11 | 0.973 | 0.745 | 16.75 |

On the contrary, the HOMO levels of ULLA9-11 are well matched with the perovskite, but these molecules could be limited by dissatisfactory hole mobility. In this case, PSCs based on ULLA9 exhibited the highest PCE (17.75%), followed by ULLA8 (17.17%), ULLA11 (16.75%), and ULLA10 (15.81%) (Table 4), showing the improved behaviour of derivatives bearing nitrogen donors at the 3-, 6-, and 9-position of the ullazine core (ULLA 8-9) compared to their 6-methyl substituted analogues (ULLA10-11). Besides the previously discussed hole mobility differences among ULLAs (Figure 4A and Table 1), the observed PCE trend might also reflect their different stacking mode onto the perovskite surface. To prove this hypothesis, the stacking behaviour of ULLA8-11 onto $FAPbI_3$ perovskite surface was investigated by *ab initio* molecular dynamics (MD) simulations using CP2K package at 343.15 K (70 °C), a temperature within the range of the standard operating conditions of PSCs (65°C-85°C), over a time of several tenth of picoseconds (ps) with time steps equal to 1 femtosecond (fs). For the whole set of investigated molecules, the ullazine core ensures the stacking onto the perovskite, as well as a degree of intramolecular $\pi$-stacking. However, the presence of different substituents significantly affects the stacking mode. In this regard, ULLA9 bearing three planar 3,6-dimethoxy-9H-carbazole substituents exhibits the best planar stacking onto the perovskite surface, a favourable condition for efficient charge injection and transporting. For the analogue ULLA8 bearing three bis(4-methoxyphenyl)amine substituents, surface stacking is slightly less planar. In addition, finite temperature dynamics stacking lost for LTLLA8, whereas it is maintained for ULLA9 that also still exhibits intramolecular $\pi$-stacking for 29 ps dynamics. Replacing the nitrogen substituent at the 6-position of the ullazine core with a methyl group (ULLA10 and ULLA 11) has a negative effect on intramolecular $\pi$-stacking. Molecules deposited on top of each other onto the perovskite surface are displaced and the offset impedes the interaction of side anchoring groups. Overall, the degree of ordered stacking (ULLA9 > ULLA8 > ULLA11 > ULLA10) is consistent with the observed PCE differences within the ULLAs series. In addition, the high temperature MD also indicates that ULLA9 might exhibit the highest stability due to the stable interface contact. It was therefore possible to optimize the orientation and energy level of ULLAs *via* molecular engineering, but their poor hole mobility under dopant-free conditions is reflected by PCEs inferior to those of state-of-the-art PSCs.

*Table 5 The PVparameters of devices based on DF PDCBT and the DD-MOS by ULLAs*

| Devices | $J_{sc}$ [mA cm$^{-2}$] | $V_{oc}$ [V] | FF | PCE [%] |
|---|---|---|---|---|
| PDCBT | 23.34 | 0.953 | 0.725 | 16.12 |
| ULLA8/PDCBT | 23.77 | 0.992 | 0.775 | 18.27 |
| ULLA9/PDCBT | 23.97 | 1.005 | 0.788 | 18.98 |
| ULLA10/PDCBT | 23.68 | 0.981 | 0.764 | 17.74 |
| ULLA11/PDCBT | 23.75 | 0.987 | 0.766 | 17.95 |

*Table 6 The PV parameters of devices based on DD-MOS construct by P3HT and ULLAs*

| Devices | $J_{sc}$ [mA cm$^{-2}$] | $V_{oc}$ [V] | FF | PCE [%] |
|---|---|---|---|---|
| P3HT | 24.03 | 0.975 | 0.705 | 16.47 |
| ULLA8/P3HT | 24.55 | 1.082 | 0.796 | 21.14 |
| ULLA9/P3HT | 24.70 | 1.097 | 0.801 | 21.70 |
| ULLA10/P3HT | 24.32 | 1.063 | 0.774 | 20.00 |
| ULLA11/P3HT | 24.45 | 1.074 | 0.787 | 20.66 |

PSCs fabricated with various types of DD-MOS junctions ensuring hole transportation gave promising results. As shown Figure 7A, right, and Table 5, PSCs based on DD-MOS ULLAs/PDCBT, ((8P), (9P), (10P) and (11P)), exhibit higher PCEs than those based on the corresponding neat PDCBT or ULLAs as HTMs. In particular, DD-MOS (9P) gave PCE = 18.98% (FF = 0.788) against 16.12% (FF = 0.725) and 17.75% (FF = 0.754) for PDCBT and ULLA9, respectively. When P3HT was employed as D2 (Table 6), the PCE of devices based on DD-MOS (9H) improved from 16.47% (neat P3HT) and 17.75% (neat ULLA9) to 21.7%, with an enhancement of $V_{oc}$ of about 100 mV. The general improvement of PV performance verified the expected benefits of DD-MOS on the hole transportation process, but it is also worth noting that ULLA9 based DD-MOS consistently afforded higher PCEs than DD-MOS based on the other ULLAs. To better

understand the origin of this trend, the interfacial contact and molecular orientation within DD-MOS PDCBT/ULLAs were further studied by Grazing incidence wide-angle X-ray scattering (GIWAXS). The bare PDCBT film has particular orientation at q= 0.3 and 0.6 Å due to the planar structure core of the polymer. When PDCBT was deposited on ULLAs, the bottoms HTMs seemingly does not influence the orientation of PDCBT, despite ULLA9 and ULLA11 exhibit an orientation at q near to 2.0 Å. Because these measurements concern multilayers of PDCBT cast on the substrate, the single molecules interaction at the contact interface are possibly overlooked. Therefore, MD of the single molecules contact was performed for over 100 ps at the temperature of 343.15 K (70°C). The interactions of ULLA9 and ULLA11 with PDCBT are reduced in comparison with those of ULLA8 and ULLA10, which are favoured by the presence of the bis(4-methoxyphenyl)amine substituents. Indeed, the 4-methoxyphenyl fragments of ULLA8 and ULLA10 attract thiophene rings and alkyl chains of PDCBT. This causes folding and disordering both within the HTM layer and at the level of the polymer chain, and breaks the stacking order of the HTM cores. In contrast, ULLA9 and ULLA11 only slightly interact with PDCBT, preserving both the stacking order in the HTM layer, to which both the ullazine core and the attached carbazole units contribute, and ordering of the polymer. The interactions with PDCBT in this case occur between both the HTM core and carbazole fragments with the thiophene rings. Therefore, the degree of order for the DD-MOS interfaces ULLAs/PDCBT is ULLA9 > ULLA8 > ULLA11 > ULLA10, which is consistent with the observed PCE differences and offers useful indications about the stability of the DD-MOS under PSCs operating conditions.

*Table 7 The PV parameters of devices based on DF-PDCBT and the DA-MOS by Na-PBA*

| Devices | $J_{sc}$ [mA cm$^{-2}$] | $V_{oc}$ [V] | FF | PCE [%] |
|---|---|---|---|---|
| PDCBT | 23.34 | 0.953 | 0.725 | 16.12 |
| PDCBT/Na-PBA 3mg | 24.42 | 1.046 | 0.76 | 19.41 |
| PDCBT/Na-PBA 5 mg | 24.63 | 1.08 | 0.791 | 21.04 |
| PDCBT/Na-PBA 8 mg | 24.57 | 1.064 | 0.776 | 20.28 |

*Table 8 The PV parameters of devices based on DF PDCBT and the DA-MOS by BCF*

| Devices | $J_{sc}$ [mA cm$^{-2}$] | $V_{oc}$ [V] | FF | PCE [%] |
|---|---|---|---|---|
| PDCBT | 23.34 | 0.953 | 0.725 | 16.12 |
| PDCBT/BCF 3mg | 24.21 | 1.059 | 0.777 | 19.92 |
| PDCBT/BCF 5 mg | 24.77 | 1.09 | 0.804 | 21.70 |
| PDCBT/BCF 8 mg | 24.71 | 1.07 | 0.784 | 20.71 |

The PV performances of PSCs featuring DA-MOS based on PDCBT and P3HT are exhibited in Figure 7B, left, and Tables 3, 4, 7, and 8. All cells were fabricated using solutions of BCF, Na-PBA or N-PBA acceptors at the optimized concentration of 5 mg/mL. In the case of PDCBT as the donor, the PCEs of PSCs featuring DA-MOS (PB), DA-MOS (PNa) and DA-MOS PN) boosted to 21.70%, 21.04% and 20.23%, respectively, with largely enhanced $V_{oc}$ as compared to bare PDCBT as the HTM (PCE = 16.12%). Among the examined acceptors, BCF also ensured the best results when DA-MOS containing P3HT as the donor were implemented, with PCE = 20.14% that favourably compares with PCE = 16.47% for bare P3HT. These results confirm the enhanced hole collection ability achievable by employing DA-MOS.

*Table 9 The PV parameters of devices based on DDA-MOS construct by ULLA9, PDCBT, P3HT and various acceptors*

| Devices | $J_{sc}$ [mA cm$^{-2}$] | $V_{oc}$ [V] | FF | PCE [%] |
|---|---|---|---|---|
| ULLA9/PDCBT/BCF | 24.91 | 1.145 | 83.9 | 23.92 |
| ULLA9/PDCBT/Na-PBA | 24.87 | 1.128 | 83.1 | 23.31 |
| ULLA9/PDCBT/N-PBA | 24.81 | 1.112 | 82.4 | 22.73 |
| ULLA9/P3HT/BCF | 24.80 | 1.125 | 83.3 | 23.24 |
| ULLA9/P 3 HT/Na-PB A | 24.72 | 1.108 | 82.5 | 22.59 |
| ULLA9/P3HT/N-PBA | 24.61 | 1.106 | 80.4 | 21.68 |

*Table 10 The PV parameters of devices based on DDA-MOS construct by ULLAs, PDCBT and BCF*

| Devices | $J_{sc}$ [mA cm$^{-2}$] | $V_{oc}$ [V] | FF | PCE [%] |
|---|---|---|---|---|
| ULLA8/PDCBT/BCF | 24.75 | 1.124 | 83.0 | 23.09 |
| ULLA9/PDCBT/BCF | 24.91 | 1.145 | 83.9 | 23.92 |
| ULLA10/PDCBT/BCF | 24.65 | 1.103 | 81.3 | 22.10 |
| ULLA11/PDCBT/BCF | 24.71 | 1.115 | 82.6 | 22.75 |

To integrate the benefits of DD-MOS and DA-MOS, DDA-MOS based PSCs were fabricated. Their statistical PCEs and the corresponding *J-V* curves are exhibited in Figure 7B, right. PCEs are largely improved in comparison with those achieved using neat ULLAs, P3HT or PDCBT under DF (dopant-free) conditions, with an average PCE of 22% for DDA-MOS as opposed to 16% for the DF-HTMs (Figure 6). The use of DDA triads ULLA9/PDCBT/BCF (9PB) and ULLA9/P3HT/BCF (9HB) (*J-V* curves in Figure 7B, right, and Tables 9 and 10) results in the champion efficiencies of 23.92% (FF=0.839, $V_{oc}$=1.145 V) and 23.24% (FF=0.833, $V_{oc}$=1.125 V), respectively (Table 9). The reverse and forward scans (Table 11) show that PSCs based on DDA-MOS (9PB) or (9HB) exhibit very low hysteresis index of 0.015 and 0.029, with stable steady-state efficiency under Maximum power output point (MPP) of 23.81% and 23.13% after 120 s outputting, respectively. The incident photon-to-current efficiency (IPCE) between 375 and 900 nm was measured to verify the accuracy of the $J_{sc}$ of devices; the integrated current of PSCs based on DDA-MOS (9PB) and DDA-MOS (9HB) from IPCE achieved 24.35 and 23.97 mA/cm$^2$, respectively, which were identical to the current obtained from the *J-V* measurements. The Mott-Schottky curves for devices based on PDCBT, ULLA9, DD-MOS (9P), DA-MOS (PB), and DDA-MOS (9PB), where the x axis intercepts indicate the flat-band potentials ($V_{fb}$), were further employed to probe the build-in field ($E_{bi}$) enhancement. The $V_{fb}$ of the construction based on MOS is largely higher than that of bare PDCBT or ULLA9, which verifies the positive effect on $E_{bi}$.

*Table 11 The reverse and forward scans of PV parameters of devices based on DDA-MOS construct by ULLA9, P3HT, PDCBT and BCF*

| Devices | $J_{sc}$ [mA cm$^{-2}$] | $V_{oc}$ [V] | FF | PCE [%] |
|---|---|---|---|---|
| Reverse ULLA9/PDCBT/BCF | 24.91 | 1.145 | 83.9 | 23.92 |
| Forward ULLA9/PDCBT/BCF | 24.96 | 1.139 | 82.9 | 23.56 |
| Reverse ULLA9/P3HT/BCF | 24.80 | 1.125 | 83.3 | 23.24 |
| Forward ULLA9/P3HT/BCF | 24.83 | 1.116 | 81.4 | 22.55 |

*Table 12. The reverse and forwards scans of parameters of modules based on DDA-MOS construct by ULLA9, P3HT, PDCBT and BCF*

| Modules | $J_{sc}$ [mA cm$^{-2}$] | $V_{oc}$ [V] | FF | PCE [%] |
|---|---|---|---|---|
| Reverse ULLA9/PDCBT/BCF | 2.78 | 8.744 | 0.795 | 19.33 |
| Forward ULLA9/PDCBT/BCF | 2.77 | 8.8711 | 0.789 | 19.04 |
| Reverse ULLA9/P3HT/BCF | 2.76 | 8.641 | 0.791 | 18.86 |
| Forward ULLA9/P3HT/BCF | 2.74 | 8.588 | 0.77 | 18.12 |

**Example 5: Modules and stability of PSCs *via* MOS junction**

Guided by these findings, we fabricated modules based on DDA-MOS (9PB) and DDA-MOS (9HB) at a size of 6.5 cm×7 cm. The excellent photovoltaic performance observed for DDA-MOS based cells were maintained after the upscaling due to the efficient hole transportation (Figure 8A, left). As a result, the perovskite mini-modules reached an efficiency of 21.79% with an active area of 30.24 cm$^2$ and an efficiency of 19.85% considering an aperture area of 33.2 cm$^2$ (geometric FF is 91.1%) for DDA-MOS (9PB). For the DDA-MOS (9HB) based modules, the PCE reached to 21.40% under the active area condition, and 19.5% considering the aperture area. As shown in Figure 8A, right and Table 12, the modules also exhibited low hysteresis indexes of 0.015 and 0.039 for DDA-MOS (9PB) and DDA-MOS (9HB), respectively.

In addition to the PV performance, PSCs stability is another issue of importance to commercialization. The outputting stability under MPP conditions were firstly measured under $N_2$ for the PSCs based on DDA-MOS (9PB) and DDA-MOS (9HB). Both types of devices exhibited outstanding working stability and their PCEs boosted to 109% and 104.7%, respectively, after operating for 1030 h (Figure 8B, left). This could be ascribed to the absence of ionic dopants and prompted us to verify whether the use of ionic type acceptors such as N-PBA and Na-PBA and had a deleterious effect

on the stability of PSCs based on the corresponding DDA-MOS (9PN) and DDA-MOS (9PNa). Actually, stability measurements performed under the above-mentioned conditions revealed that the PCEs of PSCs based on DDA-MOS (9PN) and DDA-MOS (9PNa) decreased to 96.9% and 91.2% of the initial PCE, respectively, after operating for 1030 h. This may be attributed to the intrinsic degeneration of the acceptor upon ionic migration, which should be easier for the small $Na^+$ cation than for the bulkier dimethylanilinium cation, thus justifying the worse stability of DDA-MOS (9PNa). The effects of heat on the PSCs stability were also evaluated, by measuring their PCEs upon storage at the external temperature of 85°C. PSCs based on DDA-MOS (9PB) exhibited the highest stability (PCE = 97.8% of the initial value after 1000 h heating), which is a little higher than that observed for PSCs based on DDA-MOS (9HB) (94.5%). The thermal stabilities of PSCs based on DDA-MOS triads PDCBT/ULLAs/BCF were also compared under same conditions, with ULLA 9 giving the best result (97.8%), followed by ULLA8 (93.1%), ULLA11 (89.2%), and ULLA10 (83.6%). This trend is coherent with the different evolution of the interfacial contact of ULLAs with PDCBT and perovskite evidenced by the molecular dynamics simulations at 70 °C discussed above. When in the DDA-MOS triad PDCBT/ULLA9/acceptor the neutral acceptor BCF (97.2%) was replaced by the ionic acceptor N-PBA, the observed stability (90.6%) perceptibly decreased (ambient condition). This negative effect was even more evident in the case of the other ionic acceptor Na-PBA using which the stability further decreased to 74.9%. A similar trend was observed for the stability of PSCs based on DDA-MOS towards humid air. It is worth noting that the surfaces of BCF based DDA-MOS also exhibited higher water contact angles than those of the corresponding Na-PBA- and N-PBA based DDA-MOS, as expected considering that ionic organic derivatives are usually more hydrophilic than similar neutral molecules.

**Claims**

1. An optoelectronic or photovoltaic device comprising a light-harvesting layer (4) comprising an organic/inorganic metal halide perovskite, a hole transport layer (5) and a back contact or a counter electrode (6) **characterized in that** the hole transport layer (5) is a multilayer structure, being sandwiched between the light-harvesting layer and the back contact or the counter electrode, and comprising at least two layers, each layer comprising a different hole transport material (HTM) having a different ionization energy (IP) for each layer and being selected from donor material or acceptor material; and **in that** the layer of the hole transport layer (5) in direct contact with the light-harvesting layer (4) is a layer comprising a donor material having an IP value being ≤-5.00 eV and ≥-5.60 eV, being equal to or higher than the IP value of the organic/inorganic metal halide perovskite, and **in that** the IP value of each HTM is lower than the work function of a material of the back contact or the counter electrode.

2. The optoelectronic or photovoltaic device according to claim 1 **characterized in that** the donor material of the layer of the hole transport layer (5) in direct contact with the light-harvesting layer (4) is selected from an ullazine derivative or a polymeric p-type semiconductor.

3. The optoelectronic or photovoltaic device according to any one of the preceding claims, **characterized in that** the layer of the hole transport layer (5) overlying the layer in direct contact with the light-harvesting layer (4) comprises a hole transport material selected from a donor material having an IP value higher of 0.01 eV to 0.30 eV than the IP value of the donor material of the underlying layer in direct contact with the light-harvesting layer (4).

4. The optoelectronic or photovoltaic device according to any one of the preceding claims, **characterized in that** the layer of the hole transport layer (5) in direct contact with the back contact (6) or the counter electrode (6) comprises an acceptor material having an IP value ≤ -7.00 eV and an electron affinity (EA) value ≥-4.8 eV or an EA value being higher than the IP value of the donor material of the layer underlying the layer in direct contact with the back contact (6) or the counter electrode (6).

5. The optoelectronic or photovoltaic device according to any one of claims 1 to 3, **characterized in that** the layer of the hole transport layer (5) in direct contact with the back contact (6) or the counter electrode (6) comprises a donor material with an IP value being higher of 0.01 eV to 0.30 eV than the IP value of the donor material of the underlying layer.

6. The optoelectronic or photovoltaic device according to any one of the preceding claims, **characterized in that** the hole transport layer consists of two layers (5a,5b).

7. The optoelectronic or photovoltaic device according to any one of claims 1 to 4, **characterized in that** the hole transport layer consists of three layers (5a,5b,5c).

8. The optoelectronic or photovoltaic device according to claim 6, **characterized in that** the layer (5a) comprises a donor material and the layer (5b) comprises a donor material or an acceptor material.

9. The optoelectronic or photovoltaic device according to claim 7, **characterized in that** the layer (5a) comprises a donor material, the layer (5b) comprises a donor material and the layer (5c) comprise an acceptor material.

10. The optoelectronic or photovoltaic device according to any one of the preceding claims, **characterized in that** the donor material being a ullazine derivative is selected from a compound of formula I below:

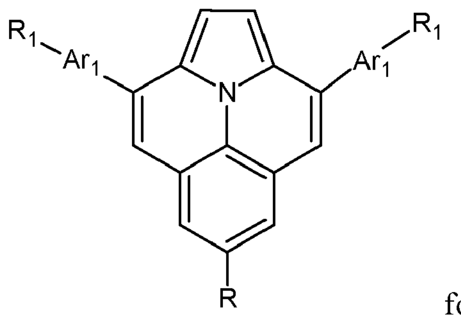

formula I,

wherein

- $Ar_1$ are identical or different, and selected from unsubstituted C6 aryl or unsubstituted C4-C5 heteroaryl comprising a heteroatom selected from O, S and N;
- $R_1$ are identical or different substituents, and selected from a moiety according to any one of formulae (Ia) and (Ib) below:

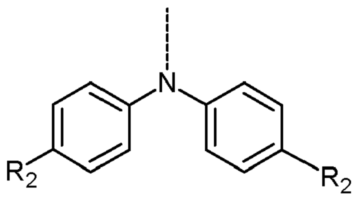

(Ia),

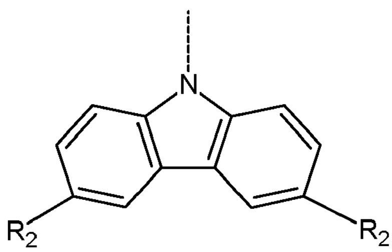

(Ib),

wherein $R_2$ are identical or different substituents and are selected from H, hydrocarbyl group comprising 1-20 carbon atoms, or hydrocarbyl group comprising 1 to 20 carbon atoms and 1 to 10 heteroatoms selected from O, S or N. wherein said hydrocarbyl groups, if said hydrocarbyl groups comprise 3 or more carbons, may be linear or branched and are unsubstituted or further substituted by halogen being selected from F, Cl, Br or I; wherein the dotted line in the structures of formulae (Ia) and (Ib) represents a single bond by which substituent $R_1$ is linked to $Ar_1$; and

- R is selected from H, halogen selected from F, Cl, Br or I, moiety of formula (Ia), moiety of formula (Ib), C1-C15 alkyl group, C1-C15 heteroalkyl group, C2-C15 alkenyl group, or C2-C15 alkynyl group, wherein one or more heteroatoms are selected from N, S or O, wherein said alkyl, heteroalkyl, alkenyl and alkynyl group, if they comprise 3 or more carbons, may be linear or branched and wherein alkyl, heteroalkyl, alkenyl, alkynyl groups are unsubstituted or further substituted by halogen being selected from F, Cl, Br or I.

11. The optoelectronic or photovoltaic device according to any one of the preceding claims, **characterized in that** the donor material being a polymeric p-semiconductor is selected from Poly(3-hexylthiophene-2,5-diyl) (P3HT) and poly [5,5'-bis(2-butyloctyl)-(2,2'-bithiophene)-4,4'-dicarboxylate-alt-5,5'-2,2'-bithiophene] (PDCBT).

12. The optoelectronic or photovoltaic device according to any one of the preceding claims, **characterized in that** the acceptor material is selected from [6,6]-phenyl-C61-butyric acid methyl ester (PCBM), buckminsterfullerene (C60), fullerene derivatives, perylene bisimide derivatives, naphthalimide derivatives, gelled ring type being 2-[(2Z)-2-[[20-[[1-(Dicyanomethylidene)-3-oxoinden-2-ylidene]methyl]-12,12,24,24tetrakis(4-hexylphenyl)-5,9,17,21tetrathiaheptacyclo[13.9.0.03,13.04,11.06,10.016,23.018,22]tetracosa-1(15),2,4(11),6(10),7,13,16(23),18(22),19-nonaen-8-yl]methylidene]-3-oxoinden-1-ylidene] propanedinitrile ( ITIC ) , tris(pentafluorophenyl)borate (BCF), dimethylanilinium tetrakis(pentafluorophenyl) borate (N-PBA), or sodium tetrapentafluorophenyl borate (Na-PBA).

**13.** The optoelectronic or photovoltaic device according to any one of the preceding claims, further comprising a conducting support layer (1), a n-type semiconductor layer (2), and an electron transport layer (3), **characterized in that** the conducting support layer (1) is covered by the n-type semiconductor (2) in contact with the electron transport layer (3) covered by the light-harvesting layer (4) in electric contact with the hole transport layer (5) being in electric contact with and/or coated by the back contact (6) or the counter electrode (6).

**14.** The optoelectronic or photovoltaic device according to any one of the preceding claims being selected from an organic photovoltaic device, a photovoltaic solid state device, a organic/inorganic metal halide perovskite photovoltaic device, a organic/inorganic metal halide perovskite solar cell, a solid state solar cell, a n-i-p perovskite solar cell, a phototransistor or LED (light-emitting diode).

**15.** A hole transport material comprising an ullazine derivative selected from a compound of formula (I) as defined in claim 10.

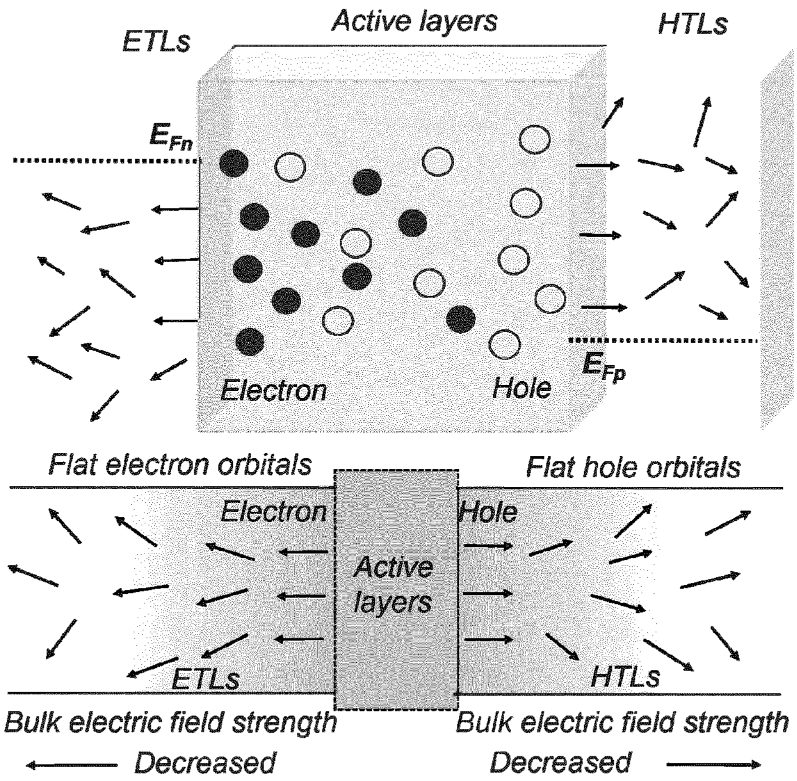


Figure 1A

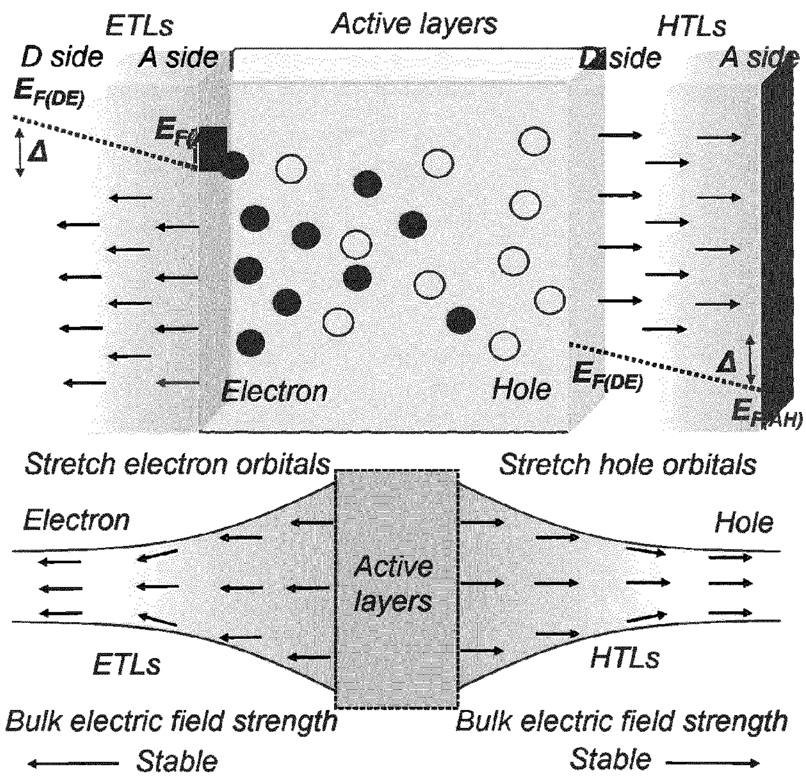


Figure 1B

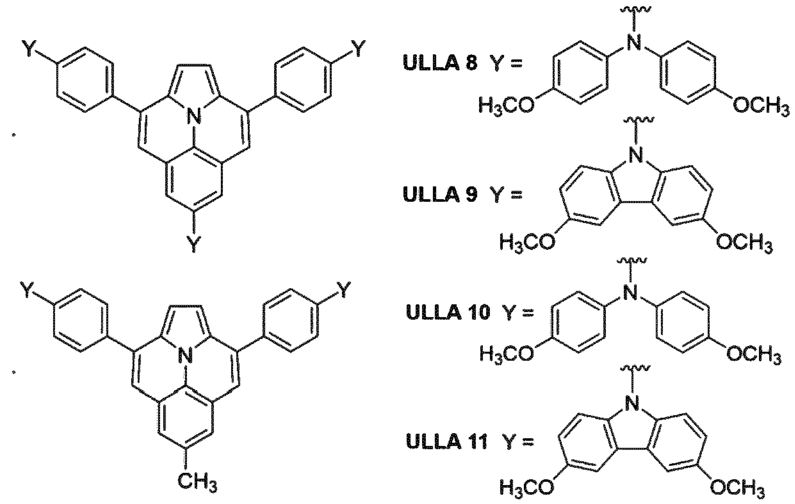

ULLA 8 Y =

ULLA 9 Y =

ULLA 10 Y =

ULLA 11 Y =

Figure 2A

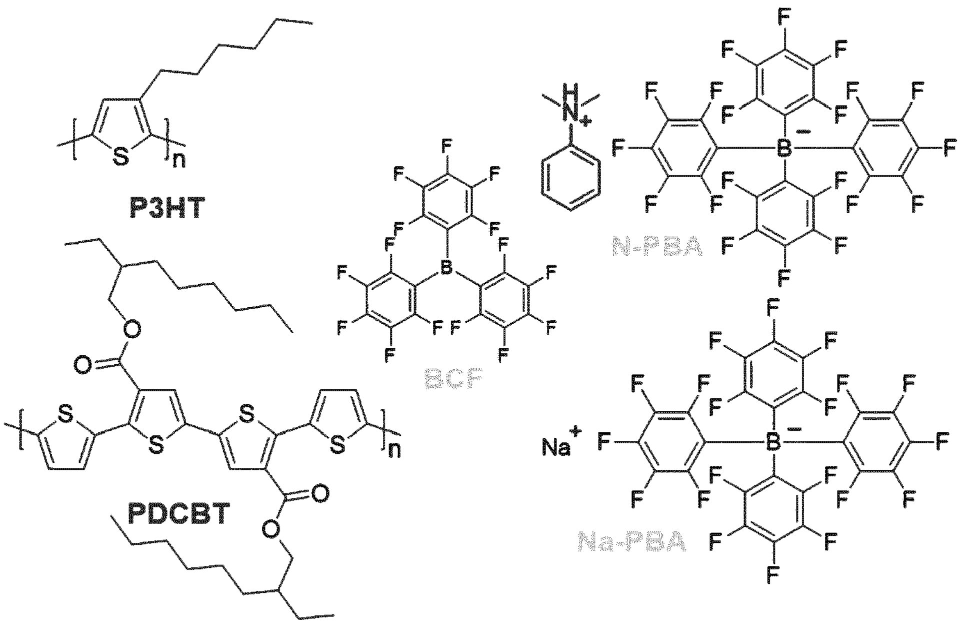

P3HT

PDCBT

BCF

N-PBA

Na-PBA

Figure 2B

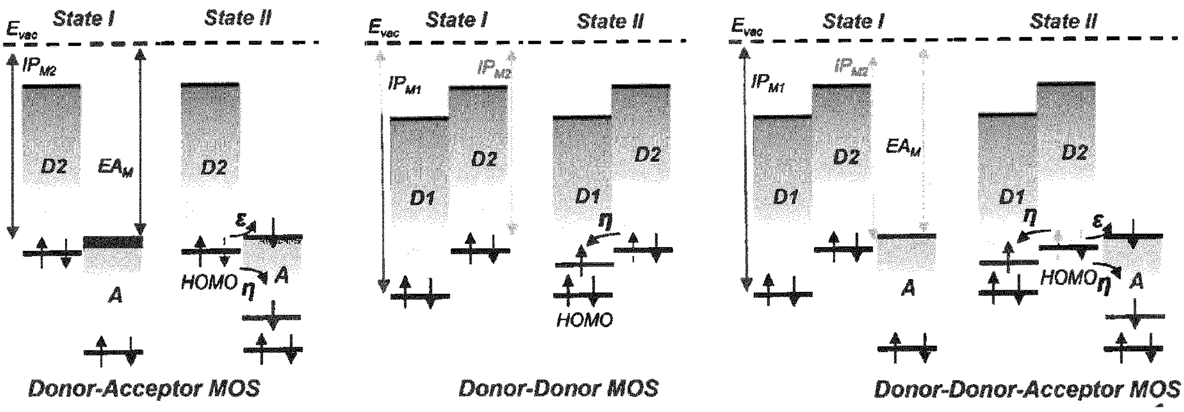


Figure 3A

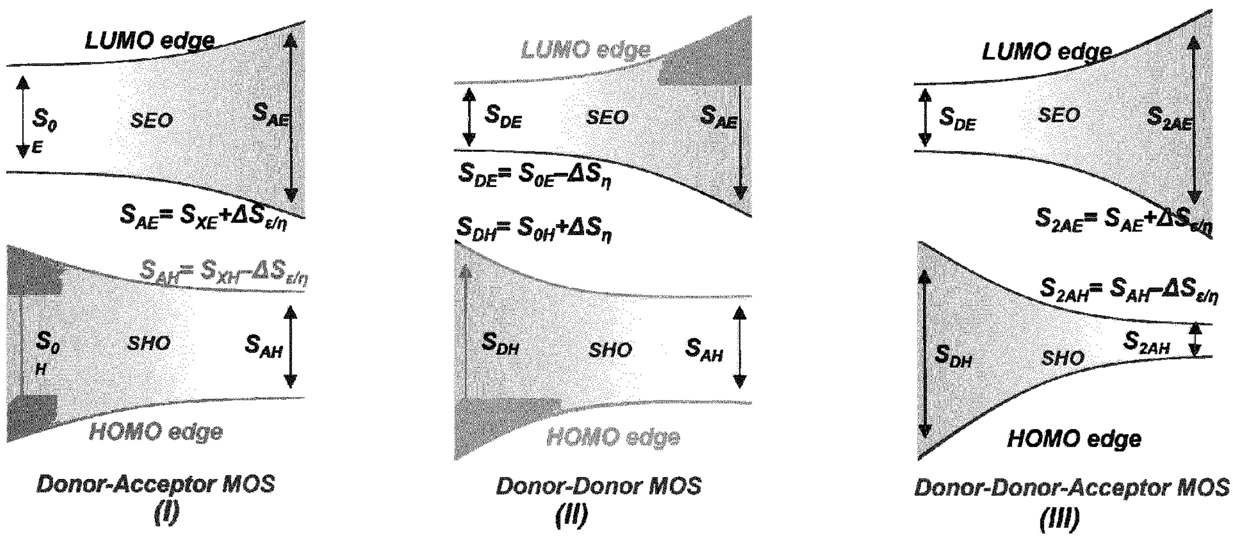


Figure 3B

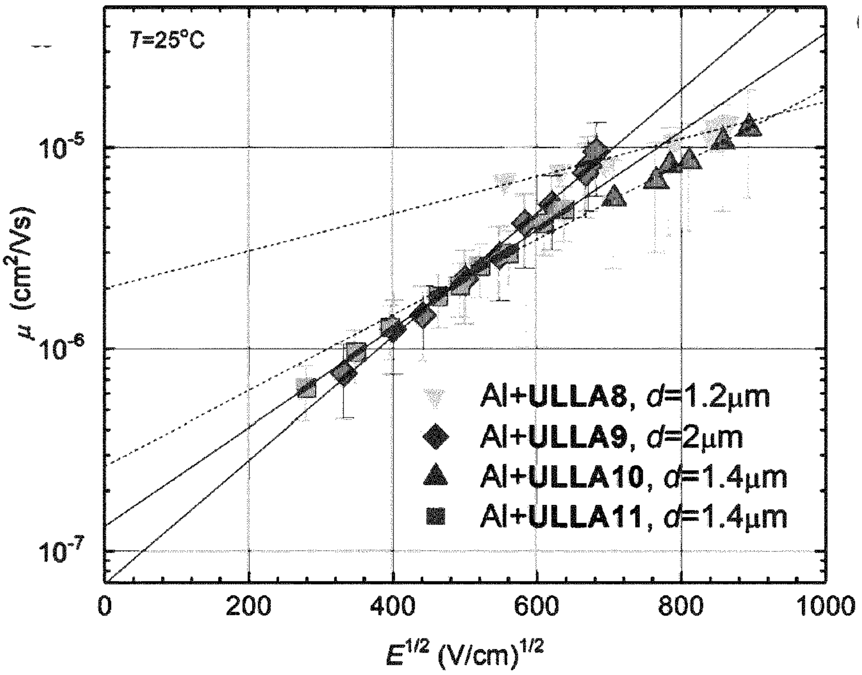


Figure 4A

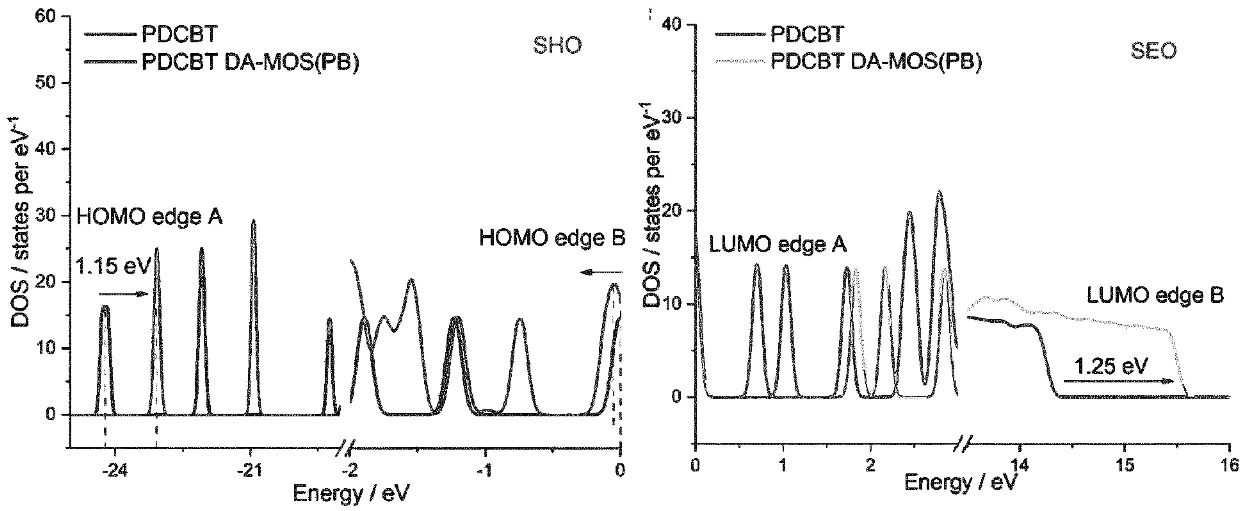


Figure 4B

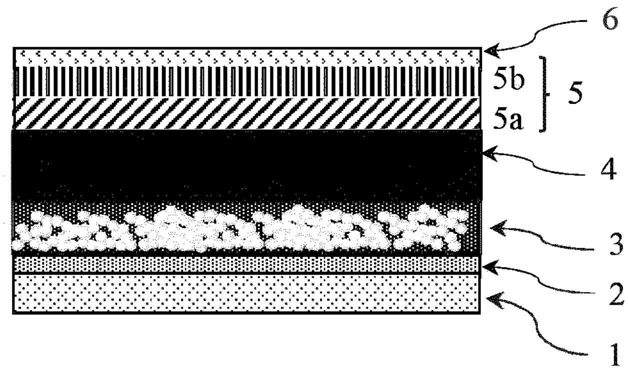


Figure 5A

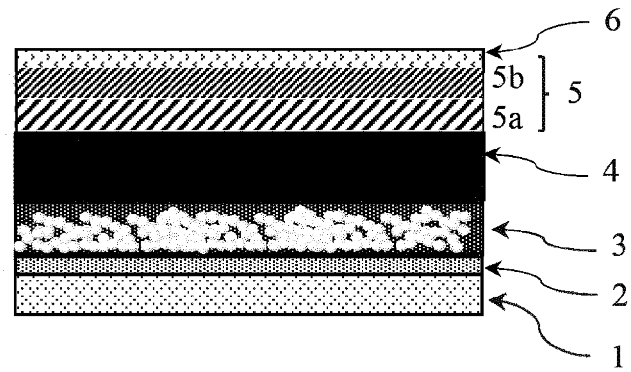


Figure 5B

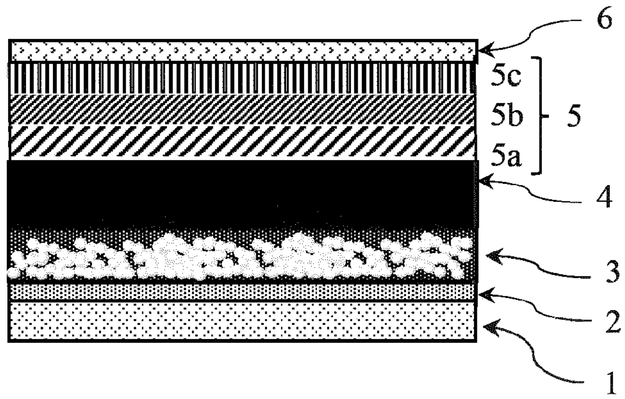


Figure 5C

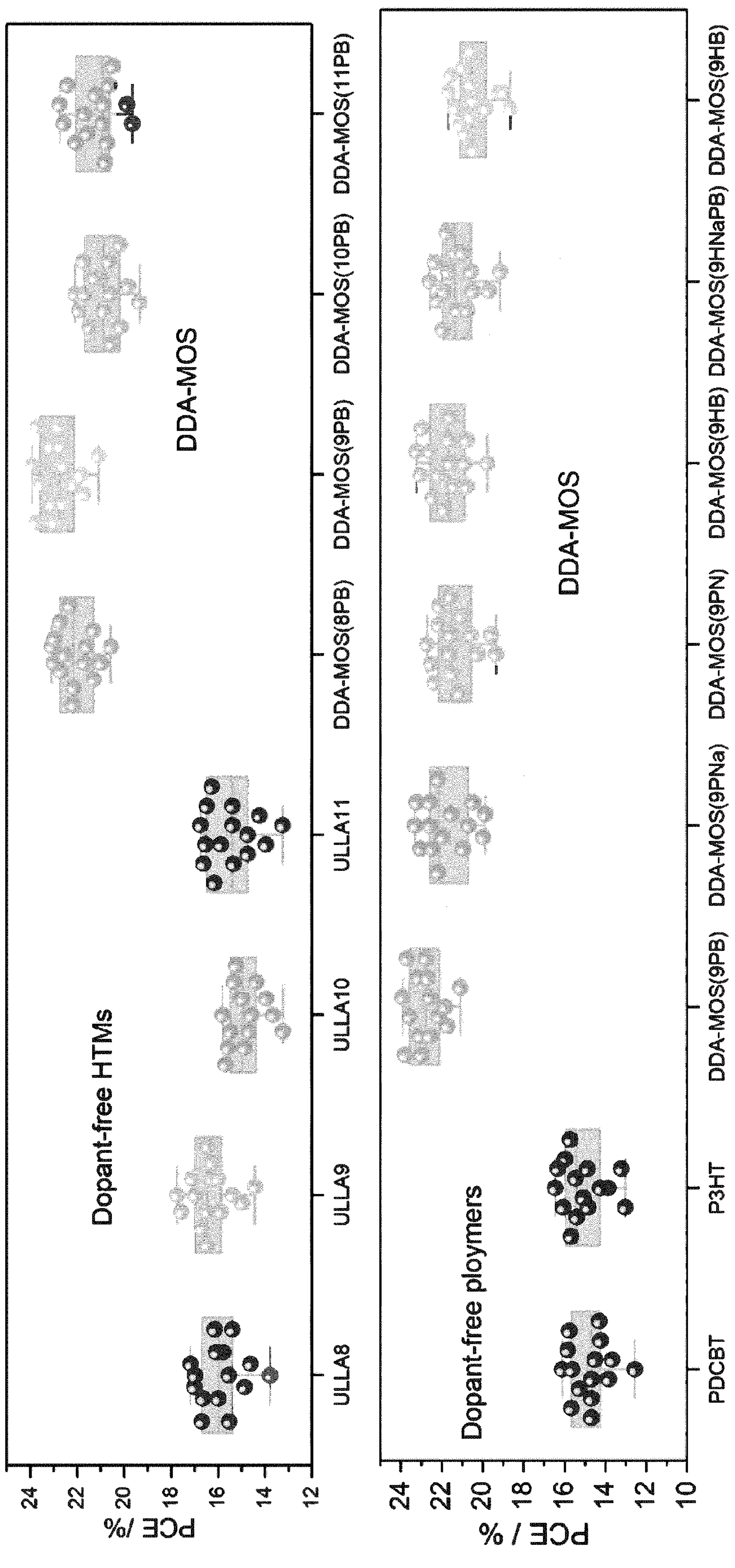
PCE /%
Dopant-free HTMs
DDA-MOS
ULLA8
ULLA9
ULLA10
ULLA11
DDA-MOS(8PB)
DDA-MOS(9PB)
DDA-MOS(10PB)
DDA-MOS(11PB)
PCE / %
Dopant-free ploymers
PDCBT
P3HT
DDA-MOS(9PB)
DDA-MOS(9PNa)
DDA-MOS(9PN)
DDA-MOS(9HB)
DDA-MOS(9HNaPB)
DDA-MOS(9HB)

Figure 6

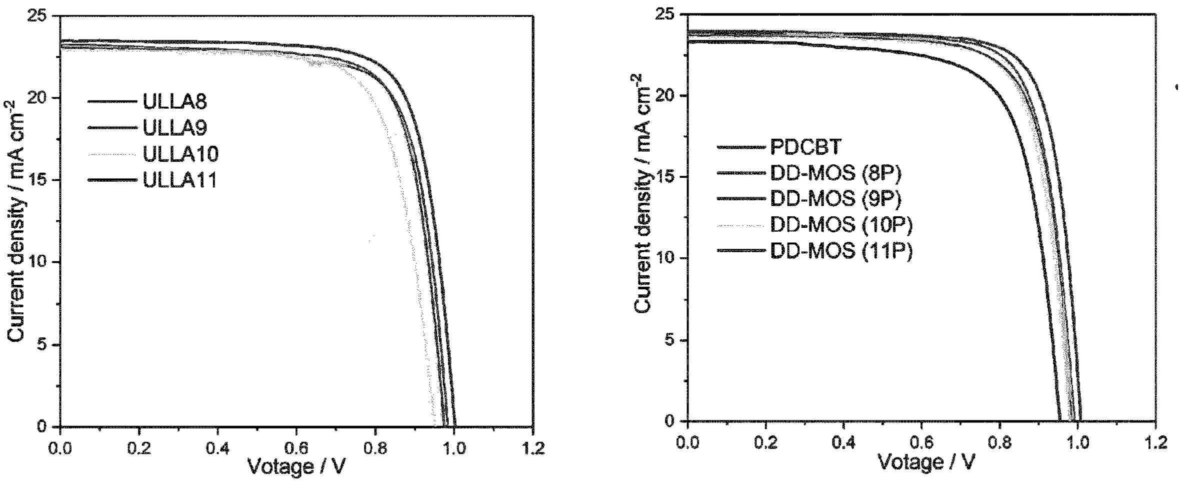


**Figure 7A**

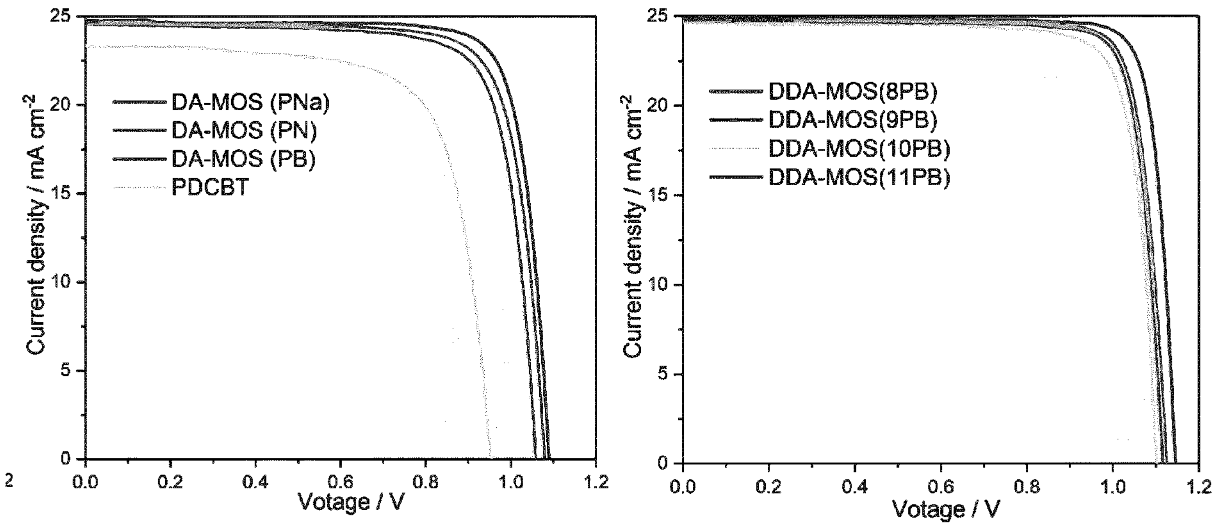


**Figure 7B**

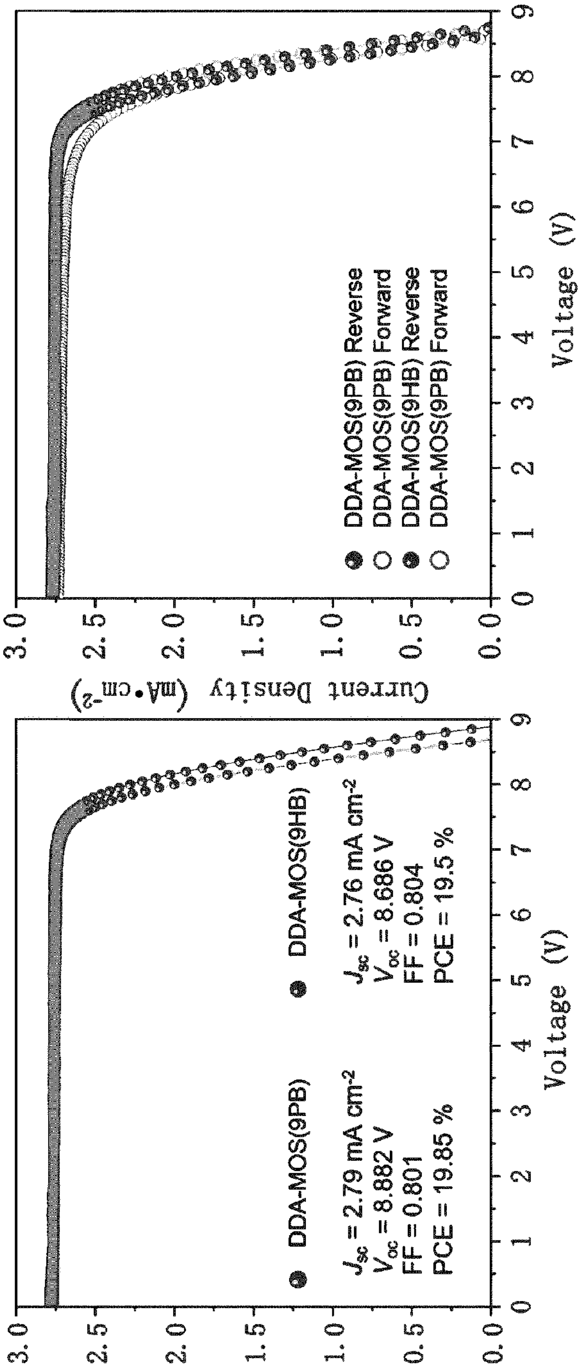


Figure 8A

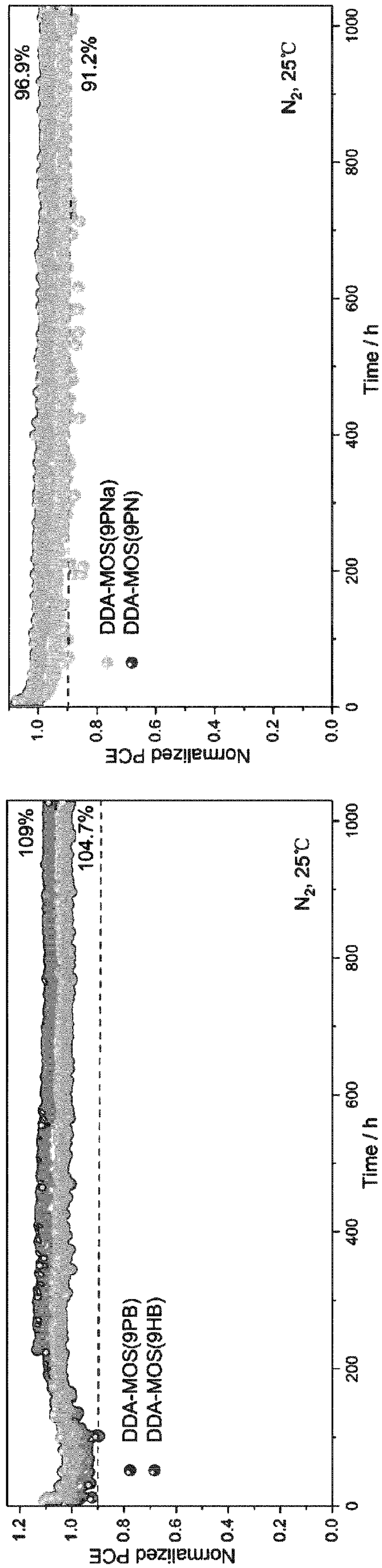


Figure 8B

Europäisches Patentamt
European Patent Office
Office européen des brevets

# EUROPEAN SEARCH REPORT

Application Number
EP 23 17 8742

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | WO 2023/097646 A1 (CONTEMPORARY AMPEREX TECHNOLOGY CO LTD [CN])<br>8 June 2023 (2023-06-08)<br>* paragraph [0042]; figures 1,2; example 2; table 1 *<br>----- | 1-6,8, 12-14<br>7,9-11 | INV.<br>H10K30/40<br>H10K30/80<br>H10K85/10<br>H10K85/60<br>C07D471/16 |
| X | CN 112 279 851 A (UNIV TIANJIN TECHNOLOGY)<br>29 January 2021 (2021-01-29)<br>* paragraphs [0055] - [0056]; compound 5b *<br>----- | 15 | |
| A | WO 2016/072092 A1 (OKINAWA INST OF SCIENCE AND TECHNOLOGY SCHOOL CORP [JP])<br>12 May 2016 (2016-05-12)<br>* claim 1 *<br>----- | 1-14 | |

TECHNICAL FIELDS SEARCHED (IPC)

H10K
C07D

The present search report has been drawn up for all claims

4

| Place of search | Date of completion of the search | Examiner |
|---|---|---|
| The Hague | 15 November 2023 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO.

EP 23 17 8742

This annex lists the patent family members relating to the patent documents cited in the above-mentioned European search report. The members are as contained in the European Patent Office EDP file on
The European Patent Office is in no way liable for these particulars which are merely given for the purpose of information.

15-11-2023

| Patent document cited in search report | Publication date | Patent family member(s) | Publication date |
|---|---|---|---|
| WO 2023097646 A1 | 08-06-2023 | CN 116965169 A | 27-10-2023 |
| | | EP 4271159 A1 | 01-11-2023 |
| | | US 2023284467 A1 | 07-09-2023 |
| | | WO 2023097646 A1 | 08-06-2023 |
| CN 112279851 A | 29-01-2021 | NONE | |
| WO 2016072092 A1 | 12-05-2016 | CN 107112419 A | 29-08-2017 |
| | | EP 3216066 A1 | 13-09-2017 |
| | | JP 6403359 B2 | 10-10-2018 |
| | | JP 2017534179 A | 16-11-2017 |
| | | KR 20170066576 A | 14-06-2017 |
| | | US 2017338430 A1 | 23-11-2017 |
| | | WO 2016072092 A1 | 12-05-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **XIA et al.** *Solar RRL*, 2022, vol. 6, 4
- **CASALEGNO et al.** *J. Chem. Phys.*, 2010, vol. 132, 094705
- **MILLER, A.** ; **ABRAHAMS, E.** *Phys. Rev.*, 1960, vol. 120, 745-755